# EUROPEAN PATENT SPECIFICATION

(11) **EP 3 291 309 B1**
(45) Date of publication and mention of the grant of the patent: **24.08.2022**
(21) Application number: 17187230.2
(22) Date of filing: 22.08.2017
(51) Int. Cl.: H01L 31/02, H02S 50/00

(54) **SAFETY SWITCH FOR PHOTOVOLTAIC SYSTEMS**
SICHERHEITSSCHALTER FÜR PHOTOVOLTAISCHE SYSTEME
COMMUTATEUR DE SÉCURITÉ POUR DES SYSTÈMES PHOTOVOLTAÏQUES

(30) Priority: 29.08.2016 US 201615250068
(43) Date of publication of application: 07.03.2018
(73) Proprietor: Solaredge Technologies Ltd., 4673335 Herzeliya (IL)
(72) Inventor: Loewenstern, Yakir, 4673335 Herzeliya (IL); Yoscovich, Ilan, 4673335 Herzeliya (IL); Braginsky, David, 4673335 Herzeliya (IL); Glovinsky, Tzachi, 4673335 Herzeliya (IL); Assia, Izak, 4673335 Herzeliya (IL)
(74) Representative: V.O.

(56) References cited:
- WO-A1-2017/125375
- WO-A2-2006/079503
- WO-A2-2009/006879
- WO-A2-2010/078303
- DE-A1-102013 101 314
- DE-A1-102013 106 808
- FR-A1- 2 894 401
- US-A1- 2011 301 772
- US-A1- 2013 313 909
- US-A1- 2014 265 551

## Description

### CROSS-REFERENCE TO RELATED APPLICATIONS

The present application claims priority to U.S. non-provisional patent application Ser. No. 15/250,068, filed August 29, 2016, entitled "Safety Switch for Photovoltaic Systems". The present application is also related to U.S. Patent Application serial no. 62/318,303, filed April 5, 2016, entitled "Optimizer Garland," and U.S. Patent Application serial no. 62/341,147, filed May 25, 2016, entitled "Photovoltaic Power Device and Wiring".

### BACKGROUND:

Safety regulations may require disconnecting and/or short-circuiting one or more photovoltaic (PV) generators or other components in case of an unsafe condition occurring in a photovoltaic installation. For example, safety regulations require that in case of an unsafe condition (e.g. a fire, a short-circuit, carrying out of maintenance work), the maximum voltage at any point in a photovoltaic installation may not exceed a safe voltage level. In some photovoltaic systems, it may be necessary to disconnect and/or short-circuit one or more photovoltaic generator(s) to achieve the safe voltage requirement. While photovoltaic systems may be deployed for tens of years, safety regulations may change at shorter time intervals (e.g. every several years). It would be advantageous to have a controllable safety switch which may be controlled to disconnect or short-circuit a PV generator in case of a safety hazard, and which may be controlled to reconnect the photovoltaic generator once the system is safe again. It would be desirable for controllable safety switches to be cost-effective and easily deployed. US2014/0265551A1 discloses a system for enabling communications via a power line conveying DC power from multiple DC power sources such as solar panels. Power and communications are provided using a single combined power and communications line. Data communication signals received over the power line are detected and compared against power line voltage for processing received data and generating data for transmission. Remote units are self-powered using power harvesting of the data communication signals. WO2006/079503 discloses a protective circuit to be electrically connected to the solar cells of a solar cell module, which is characterized by comprising a controlled electronic circuit system as the protective device, thereby providing a protective circuit to be electrically connected to the solar cells of a solar cell module, which heats up only slightly during operation.

### SUMMARY:

According to one aspect, the present invention provides an apparatus as defined in claim 1. According to a further aspect, the present invention provides a method as defined in claim 10.

Embodiments herein employ safety switches and associated apparatuses and methods for controlling currents through branches and/or voltages at nodes in photovoltaic (PV) installations.

In illustrative embodiments comprising one or more electrical systems, a group of electrical safety switches are electrically connectable to a plurality of electrical power sources. The electrical safety switches are controllable to maintain safe operation of the electrical systems.

In illustrative electrical systems, a safety switch is deployed between serially-connected photovoltaic generators in a photovoltaic installation. In some systems, safety switches may be installed between each pair of PV generators. In some systems, the number and location of safety switches may be chosen with regard to current safety regulations, and in some embodiments, the number and location of safety switches may be chosen with regard to anticipated "worst-case" safety regulations. For example, in locales where adding, reconfiguring and/or removing system components is easy and inexpensive, safety switches may be deployed in a PV installation in accordance with the safety regulations at the time the installation was built. In locales where adding, reconfiguring and/or removing system components may be difficult or expensive, safety switches may be deployed in a manner that complies with a "worst-case" (i.e. most stringent) prediction of future regulations.

Illustrative safety switches according to some embodiments may be retrofit to existing photovoltaic installations and components.

The auxiliary power circuits are used to provide power to safety switches and associated controllers. In some embodiments, safety switches are located at system points which do not carry significant electrical power when the safety switches are in a particular state (e.g., when safety switches are in the ON state). Illustrative auxiliary power circuits are disclosed herein, along with associated methods for providing power to the auxiliary power circuits and safety switches regardless of the state of the safety switches.

In some embodiments, components and design of safety switches may be selected to regulate or withstand electrical parameters when illustrative safety switches are in the ON or OFF states. For example, some illustrative safety switches may comprise shunt resistors sized to regulate electrical current flowing through safety switches when the safety switches are in the OFF position.

In some embodiments, safety switches are in communication with accompanying system devices, such as system control devices and/or end-user devices such as graphical user interfaces for monitoring applications.

Further embodiments include user interfaces for monitoring the state of and parameters measured by safety switches in illustrative power systems. A system owner or operator may be able to view a list of system safety switches, associated switch states and electrical parameter measured thereby. In some embodiments, the list may be a graphical user interface (GUI) viewable on a computing device, such as a computer monitor, tablet, smart-television, smartphone, or the like. In some embodiments, the system operator may be able to manually control safety switches (e.g. by pressing buttons).

As noted above, this Summary is merely a summary of some of the features described herein and is provided to introduce a selection of concepts in a simplified form that are further described below in the Detailed Description. The Summary is not exhaustive, is not intended to identify key features or essential features of the claimed subject matter and is not to be a limitation on the claims.

### BRIEF DESCRIPTION OF THE DRAWINGS

These and other features, aspects, and advantages of the present disclosure will become better understood with regard to the following description, claims, and drawings. The present disclosure is illustrated by way of example, and not limited by, the accompanying figures.
Fig. 1A illustrates a photovoltaic system configuration according to various aspects of the present disclosure.
Fig. 1B illustrates a photovoltaic system configuration according to various aspects of the present disclosure.
Fig. 2 illustrates part of a photovoltaic system configuration according to various aspects of the present disclosure.
Fig. 3 illustrates a safety switch according to various aspects of the present disclosure.
Figs. 4A-4B illustrate a safety switch according to various aspects of the present disclosure.
Fig. 5A illustrates part of a photovoltaic system configuration according to various aspects of the present disclosure.
Fig. 5B illustrates a photovoltaic generator according to various aspects of the present disclosure, not forming part of the present invention.
Fig. 6 illustrates a method for operating a safety switch according to various aspects of the present disclosure.
Figs. 7A-7C illustrate circuits for providing operational power to a safety switch according to various aspects of the present disclosure. The Fig. 7B circuit does not form part of the present invention.
Fig. 7D illustrates a timing diagram depicting some of the operational parameters of a safety switch according to various aspects of the present disclosure.
Fig. 7E illustrates a circuit for providing operational power to a safety switch according to various aspects of the present disclosure.
Fig. 7F illustrates a timing diagram depicting some of the operational parameters of a safety switch according to various aspects of the present disclosure.
Fig. 7G illustrates a circuit for providing operational power to a safety switch according to various aspects of the present disclosure.
Fig. 7H illustrates a circuit, not forming part of the present invention, for providing operational power to a safety switch according to various aspects of the present disclosure.
Fig. 7I illustrates part of an illustrative datasheet indicating possible operating points for operating a transistor according to various aspects of the present disclosure.
Fig. 8 illustrates a photovoltaic system configuration according to various aspects of the present disclosure.
Fig. 9 illustrates a photovoltaic power device according to various aspects of the present disclosure, not forming part of the present invention.
Fig. 10 illustrates a photovoltaic system configuration according to various aspects of the present disclosure, not forming part of the present invention.
Figs. 11A-11B illustrate photovoltaic power devices according to various aspects of the present disclosure, not forming part of the present invention.
Fig. 12 illustrates a photovoltaic system configuration according to various aspects of the present disclosure, not forming part of the present invention.
Fig. 13A illustrates circuitry of a safety switch according to various aspects of the present disclosure, not forming part of the present invention.
Fig. 13B illustrates circuitry of a photovoltaic power device according to various aspects of the present disclosure, not forming part of the present invention.
Fig. 14 illustrates a portion of a chain of photovoltaic power devices according to various aspects of the present disclosure, not forming part of the present invention.
Fig. 15 is an illustrative mockup of a user interface for an electrical system according to illustrative embodiments.

### DETAILED DESCRIPTION

In the following description of various illustrative embodiments, reference is made to the accompanying drawings, which form a part hereof, and in which is shown, by way of illustration, various embodiments in which aspects of the disclosure may be practiced. It is to be understood that other embodiments may be utilized and structural and functional modifications may be made, without departing from the scope of the present disclosure.

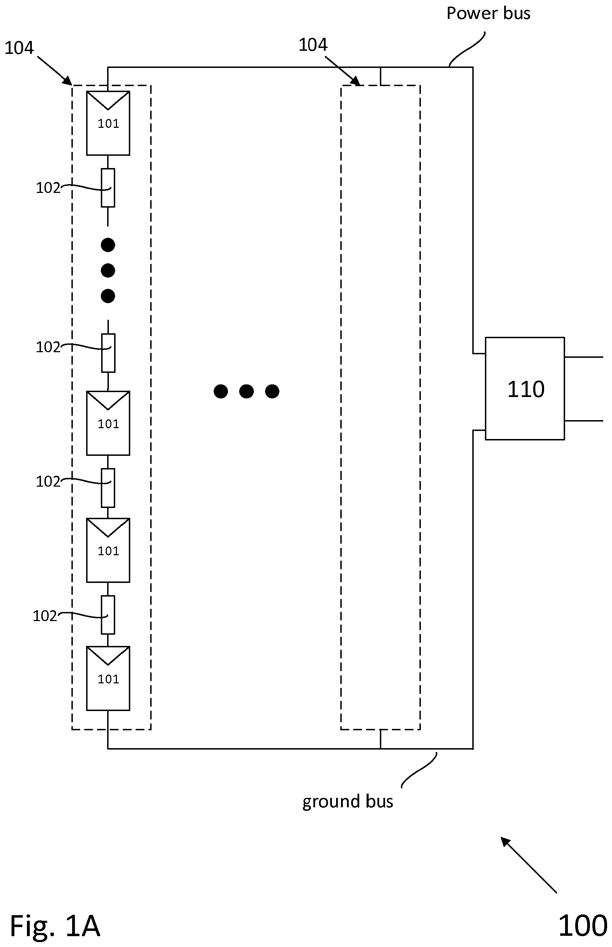

Reference is now made to Fig. 1A, which shows a photovoltaic (PV) system according to illustrative embodiments. PV system 100 may comprise a plurality of PV strings 104 coupled in parallel between a ground bus and a power bus. Each of PV strings 104 may comprise a plurality of serially-connected PV generators 101 and a plurality of safety switches 102. PV generators 101 may comprise one or more photovoltaic cells(s), module(s), panel(s) or shingle(s). In some embodiments, PV generators 101 may be replaced by direct current (DC) batteries or alternative direct current or alternating current (AC) power sources.

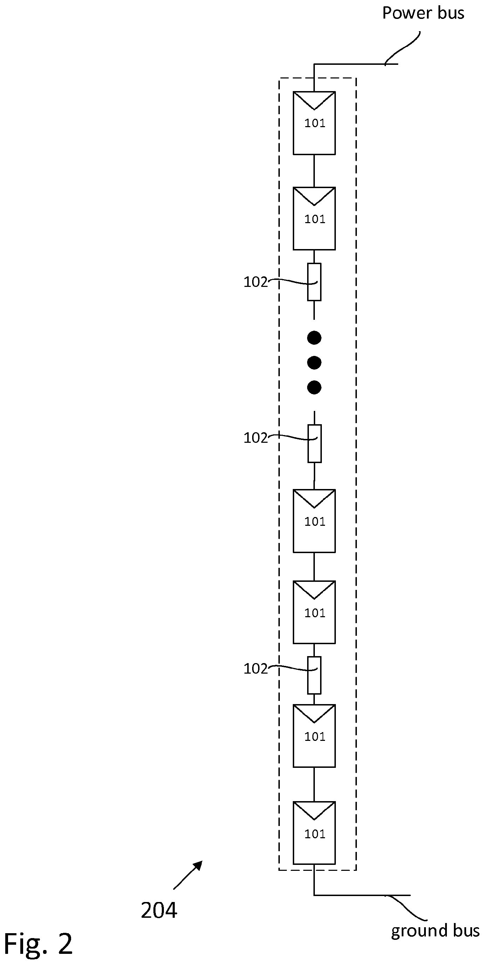

In the illustrative embodiment of Fig. 1A, a safety switch 102 is disposed between each pair of PV generators 101. In some embodiments (e.g. the embodiment shown in Fig. 2) a safety switch 102 is disposed between groups of more than one serially-connected PV generators. Safety switch 102 may comprise a control device and a communication device, and is operated to disconnect adjacent PV generators when receiving (e.g. via the communication device) a command to disconnect PV generators.

In some embodiments, the power and ground buses may be input to system power device 110. In some embodiments, system power device 110 may include a DC/AC inverter and may output alternating current (AC) power to a power grid, home or other destinations. In some embodiments, system power device 110 may comprise a combiner box, transformer and/or safety disconnect circuit. For example, system power device 110 may comprise a DC combiner box for receiving DC power from a plurality of PV strings 104 and outputting the combined DC power. In some embodiments, system power device 110 may include a fuse coupled to each string 104 for overcurrent protection, and/or one or more disconnect switches for disconnecting one or more PV strings 104.

In some embodiments, system power device 110 may include or be coupled to a control device and/or a communication device for controlling or communicating with safety switches 102. For example, system power device 110 may comprise a control device such as a microprocessor, Digital Signal Processor (DSP) and/or a Field Programmable Gate Array (FPGA) configured to control the operation of system power device 110. In some embodiments, system power device 110 may comprise multiple interacting control devices. System power device 110 may further comprise a communication device (e.g. a Power Line Communication circuit and/or a wireless transceiver) configured to communicate with linked communication devices included in safety switches 102. In some embodiments, system power device 110 may comprise both a control device and a communication device, the control device configured to determine desirable modes of operation for PV power devices (e.g. power devices 103), and the communication device configured to transmit operational commands and receive reports from communication devices included in the PV power devices.

System power device 110 may be coupled to any number of other devices and/or systems such as PV systems 100 (e.g., various discrete and/or interconnected devices such as disconnect(s), PV cell(s)/array(s), inverter(s), micro inverter(s), PV power device(s), safety device(s), meter(s), breaker(s), AC main(s), junction box(es), camera etc.), network(s)/Intranet/Internet, computing devices, smart phone devices, tablet devices, camera, one or more servers which may include data bases and/or work stations. System power device 110 may be configured for controlling the operation of components within PV system 100 and/or for controlling the interactions with other elements coupled to PV system 100.

In some embodiments, the power and ground buses may be further coupled to energy storage devices such as batteries, flywheels or other energy storage devices.

Safety regulations may define a maximum allowable voltage between the ground bus and any other voltage point in PV system 100, during both regular operating conditions and during potentially unsafe conditions. Similarly, safety regulations may define a maximum allowable voltage between any two voltage points in PV system 100. In some scenarios, an unsafe condition in PV system 100 requires disconnecting or short-circuiting one or more of the PV generators 101 in a PV string 104.

As a numerical example, an illustrative PV string 104 comprises 20 serially-connected PV generators 101. Each PV generator 101 has an open-circuit voltage of 45V. In case of an unsafe condition (e.g. a fire, detection of an arc or a dangerous short-circuit somewhere in PV system 100), safety regulations may require that system power device 110 cease drawing power from PV string 104, resulting in an open-circuit voltage of 45 · 20 = 900V across PV string 104. Safety regulations may further require that in case of an unsafe condition, the maximum voltage between any two points in PV system 100 may not exceed, for example, 80V. To comply with safety regulations, safety switches 102 disconnect the plurality of PV generators 101 comprising PV string 104, resulting in PV generators 101 (excluding the PV generators 101 coupled to the ground and power buses) having a "floating" voltage with regard to ground, and a voltage drop of about 45V between the two terminals of each PV generator.

In some embodiments, system power device 110 responds to an indication of a potentially unsafe system condition by limiting the voltage across each PV string 104. For example, system power device 110 may comprise an inverter configured to regulate a voltage of about 60V across each PV string 104 in case of a potentially unsafe condition.

According to aspects of the disclosure herein, a system power device 110 (or a retrofit safety device) may respond to an indication of a potentially unsafe system condition by short-circuiting each PV string 104. For example, system power device 110 may include a switch (not explicitly shown) disposed across the inputs to system power device 110 (between the power bus and the ground bus), and in response to an indication of a potentially unsafe power condition (e.g., detecting a grid current, voltage, frequency or harmonic content outside of an allowable range, or in response to a manually activated button), system power device 110 (or the retrofit safety device) may activate the switch to substantially connect the power bus to the ground bus, short-circuiting PV strings 104. If a PV string 104 is short-circuited, safety switches 102 included in the PV string 104 may detect (e.g., by a current sensor) that the current of the PV string 104 has risen dramatically, and may move (e.g., by a controller receiving the current measurement and controlling the switch accordingly) to the OFF state, to reduce the string voltage.

As another example, system power device 110 (or a retrofit safety device connected at the inputs of system power device 110) may include a switch (not explicitly shown) disposed in series at one or more of the inputs to system power device 110 (between the power bus and the system power device, and/or between the ground bus and the system power device), and in response to an indication of a potentially unsafe power condition (e.g., detecting a grid current, voltage, frequency or harmonic content outside of an allowable range, or in response to a manually activated button), system power device 110 (or the retrofit safety device) may activate (e.g., by moving the switch to the OFF state) the switch to disconnect the power bus and/or the ground bus from PV strings 104. If a PV string 104 is disconnected, safety switches 102 included in the PV string 104 may detect (e.g., by a current sensor) that the current of the PV string 104 has fallen dramatically, and may move (e.g., by a controller receiving the current measurement and controlling the switch accordingly) to the OFF state, to reduce the string voltage.

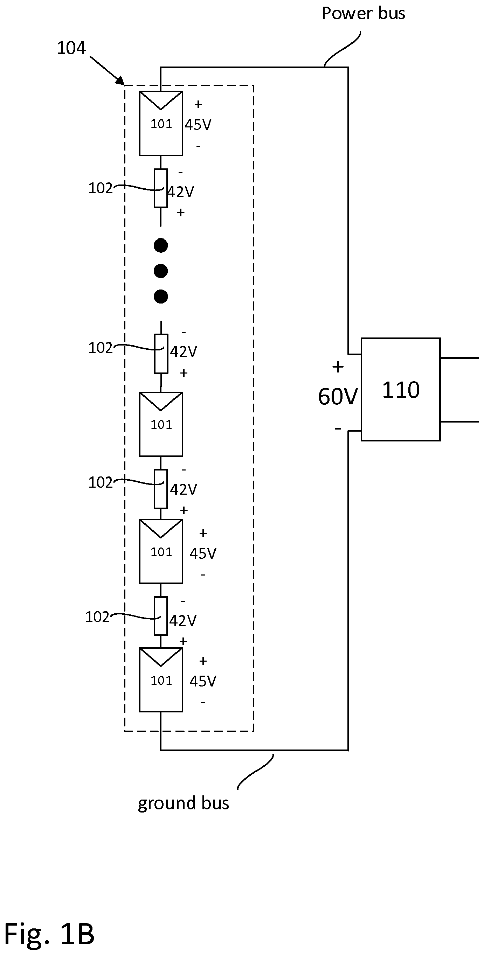

Reference is now made to Fig. 1B, which illustrates a single PV string 104 coupled to system power device 110. In case of a potentially unsafe system condition, safety switches 102 disconnect (i.e. each switch moves to the OFF state), and system power device 110 may apply a voltage to PV string 104. In the numerical example of Fig. 1B, each PV generator is assumed to be operating at an open-circuit voltage of 45V, and system power device 110 applies a voltage of 60V across PV string 104. Safety switches 102, in accordance with embodiments disclosed herein, may be configured to provide and withstand a voltage drop of opposite polarity to the PV generators. In the numerical example of Fig. 1B, PV string 104 comprises twenty PV generators 101 and twenty safety switches 102. Each PV generator has a positive voltage drop of 45V, and each safety switch 102 has a negative voltage drop of 42V, providing a string voltage of (45 - 42) · 20 = 60*V.* It may be noted that the voltage drop between each pair of locations in the PV system does not exceed 60V.

It is to be noted that the ratio of photovoltaic generators to safety switches, and the location of safety switches, may change depending on electrical parameters of photovoltaic generators and safety regulations. For example, if low-voltage PV generators (e.g. PV generators having an open-circuit voltage of 10V) are used as PV generators 101, and safety regulations allow a maximum point-to-point voltage of 55V in case of a potentially unsafe condition, a single safety switch 102 may be disposed per five PV generators 101. If safety regulations are changed to allow a maximum point-to-point voltage of 45V in case of a potentially unsafe condition, additional safety switches 102 may be added.

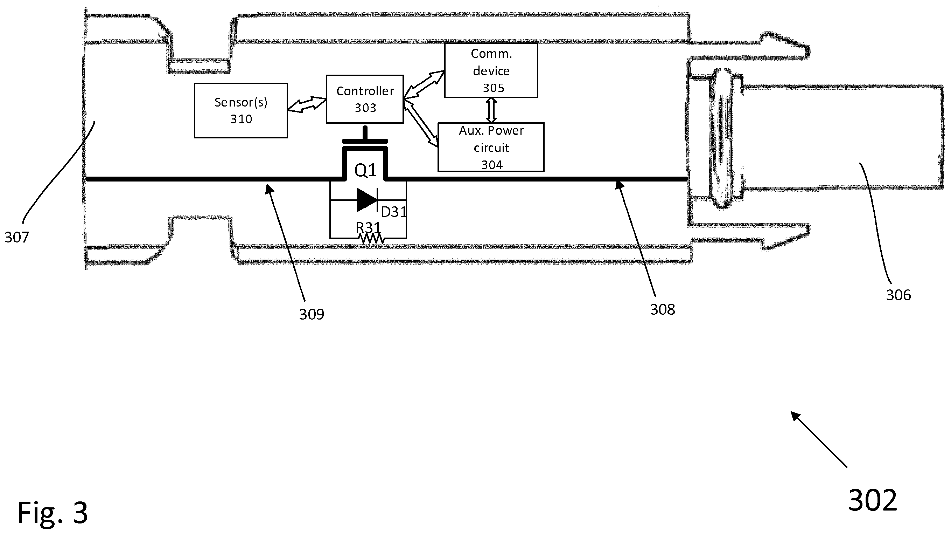

Safety switches 102 may comprise a resistor for regulating current through safety switches 102 when the switches are in the OFF state. For example, each of safety switches 102 may comprise a shunt resistor (e.g. resistor R31 of Fig. 3) having a resistance of about 1kΩ, to regulate the OFF-state current to be about 42V/1kΩ = 42mA. In general, the value of a shunt resistor may vary according to expected OFF-state voltages and currents, and may be between 10Ω and 5kΩ.

In some embodiments, the values may vary depending on the regulated voltage provided by system power device 110 and the open-circuit voltage of each PV generator 101. For example, string 104 may comprise ten PV generators, and ten safety switches, each PV generator having an open-circuit voltage of 30V, and system power device 110 may provide a voltage of 50V across PV string 104. In that case, each safety switch may be operated to have a negative voltage of 25V, providing the string voltage of (30 - 25) · 10 = 50*V*.

Reference is now made to Fig. 2, which shows a photovoltaic string according to illustrative embodiments. PV string 204 comprises a plurality of PV generators 101 and safety switches 102. PV generators 101 may be similar to or the same as PV generators 101 of Fig. 1A, and safety switches 102 may be similar to or the same as safety switches 102 of Fig. 1. Safety switches 102 may be installed between each pair of PV generators 101, such that each PV generator 101 (excluding the PV generators connected to the ground and power buses) has a first terminal connected to a different PV generator 101 and a second terminal connected to a safety switch 102. The arrangement illustrated in Fig. 2 may be appropriate in systems where the maximum allowed safe voltage is greater than or equal to double the open-circuit voltage of a single PV generator 101. For example, if each PV generator 101 has an open-circuit voltage of 45V and the maximum allowed safe voltage is 100V, or each PV generator 101 has an open-circuit voltage of 30V and the maximum allowed safe voltage is 80V, the arrangement illustrated in Fig. 2 may reduce costs by reducing the required number of safety switches while still complying with safety regulations.

Reference is now made to Fig. 3, which illustrates a safety switch according to illustrative embodiment. Safety switch 302 may be used as safety switch 102 in Fig. 1A and Fig. 2. Safety switch may comprise male connector 306 and female connector 307, male connector 306 designed to fit a female connector features by a PV generator (e.g. PV generator 101) and female connector 307 designed to fit a male connector features by a PV generator. Conductor 308 may provide an electrical connection to male connector 306, and conductor 309 may provide an electrical connection to female connector 307. In some embodiments, various interconnecting connectors may be used. Safety switch 302 includes a switching element disposed between conductor 308 and conductor 309. Referring to Fig. 3, transistor Q1 is used as a switching element disposed between conductor 308 and conductor 309. Safety switch 302 further includes controller 303 for controlling the operation of transistor Q1. Transistor Q1 may be realized using various electrical devices, such as Metal-Oxide-Semiconductor Field Effect Transistor (MOSFET), Junction gate field-effect transistor (JFET). In some embodiments, transistor Q1 may be realized using multiple transistors connected in parallel, to improve electrical performance (e.g. to reduce losses). In the illustrative embodiments disclosed herein, transistor Q1 and similar switching elements will be assumed to be MOSFETs comprising a body diode. Diode D31 may be the body diode of transistor Q1. In some embodiments (e.g. in case Q1 is a MOSFET comprising a low-quality body diode) a separate diode may be coupled in parallel to diode D31 to function as an alternative bypass diode. Diode D31 may be oriented to prevent forward bias of diode D31 when the transistor is in the OFF position. Resistor R31 may be disposed across the terminals of transistor Q1. Resistor R31 may be sized to regulate the OFF-state resistance across the terminals of transistor Q1. For example, if the anticipated OFF-state voltage drop across transistor Q1 is 40V, and the desired OFF-state leakage current through safety switch 302 is 20mA, R31 may be about 40V/20mA = 2000Ω. In some embodiments, R31 might not be featured (e.g. if there is no need or desire to regulate the OFF-state leakage current).

Safety switch 302 may comprise communication device 305 for communicating with other devices and controller 303 for controlling the operation (e.g. turning ON and OFF) of transistor Q1. Controller 303 may be an analog circuit, microprocessor, Digital Signal Processor (DSP), Application-Specific Integrated Circuit (ASIC) and/or a Field Programmable Gate Array (FPGA). In some embodiments, communication device 305 may receive a command from an external device to change the state of transistor Q1, and communication device 305 may convey the command to controller 303. Communication device 305 may communicate with external devices using various technologies such as Power Line Communications (PLC), acoustic communications transmitted over conductors 308 and 309, and wireless communication protocols (e.g. Wi-Fi^{™}, ZigBee^{™}, Bluetooth^{™}, cellular communications, etc.).

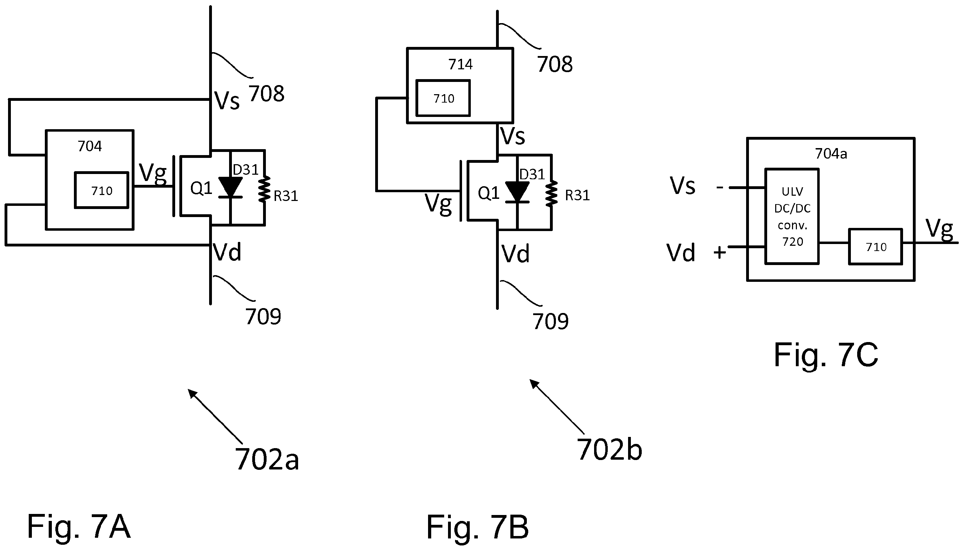

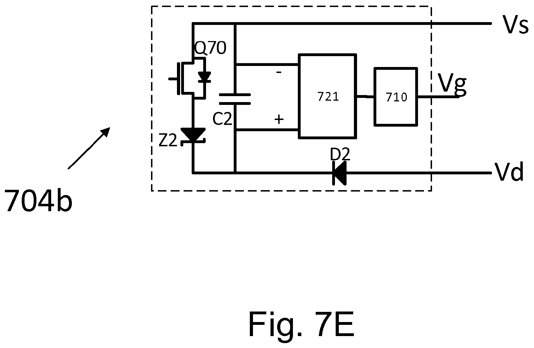

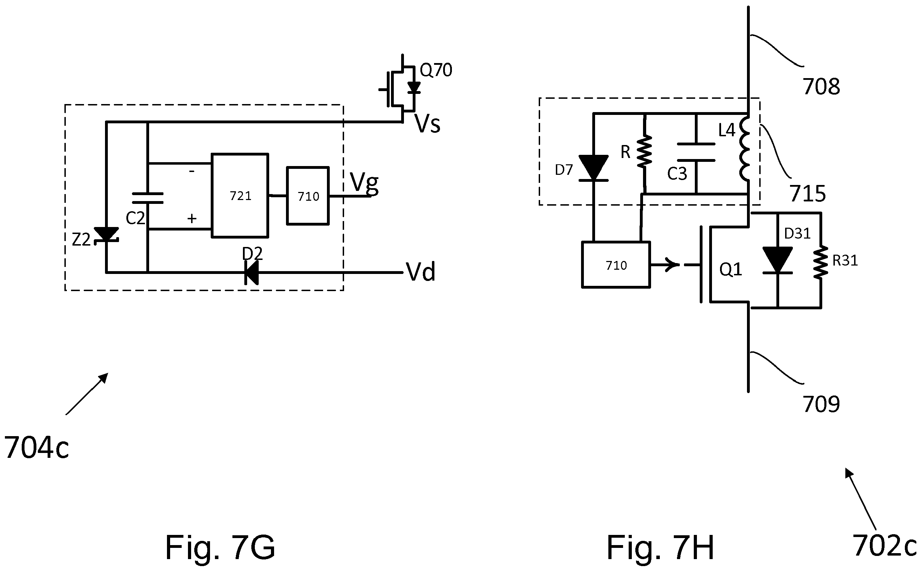

Auxiliary power circuit 304 is coupled to conductors 308 and 309, and provides power to controller 303, and may provide power to sensor(s)/sensor interface(s) 310 and/or communication device 305. Auxiliary power circuit 304 may be variously realized, with illustrative embodiments disclosed herein (e.g. in Figs. 7A-7C, 7E, 7H). In some embodiments, two or more of controller 303, auxiliary power circuit 304 and communication device 305 may be integrated as a single unit. For example, in Fig. 7C, communication device 305 may receive a PLC signal which also provides power to controller 303.

In some embodiments, safety switch 302 may further comprise measurement sensor(s) and/or sensor interface(s) 310 for measuring parameters such as current, voltage and/or temperature. For example, sensor(s)/sensor interface(s) 310 may include a current sensor for measuring the current through conductor 308 or conductor 309, and/or a voltage sensor for measuring the voltage drop across transistor Q1, and/or a temperature sensor for measuring the temperature at or near male connector 306, female connector 307 and/or transistor Q1. In some embodiments, sensor(s)/sensor interface(s) 310 may provide measurements to controller 303, with controller 303 configured to take action (e.g. change the state of transistor Q1) according to the measurements received. For example, controller 303 may be configured to set the state of Q1 to OFF if a high current is measured through conductor 309, or if a high temperature is measured near male connector 306. In some embodiments, controller 303 may provide the measurements obtained from sensor(s)/sensor interface(s) 310 to communication device 305, with communication device 305 configured to transmit the measurements to a system controller or data-collection device (not explicitly depicted), such as system power device 110 of Fig. 1. In some embodiments, sensor(s)/sensor interface(s) 310 may provide measurements directly to communication device 305, bypassing controller 303.

The present invention includes providing transistor Q1 for safety features (e.g. the ability to disconnect two PV generators from each other).

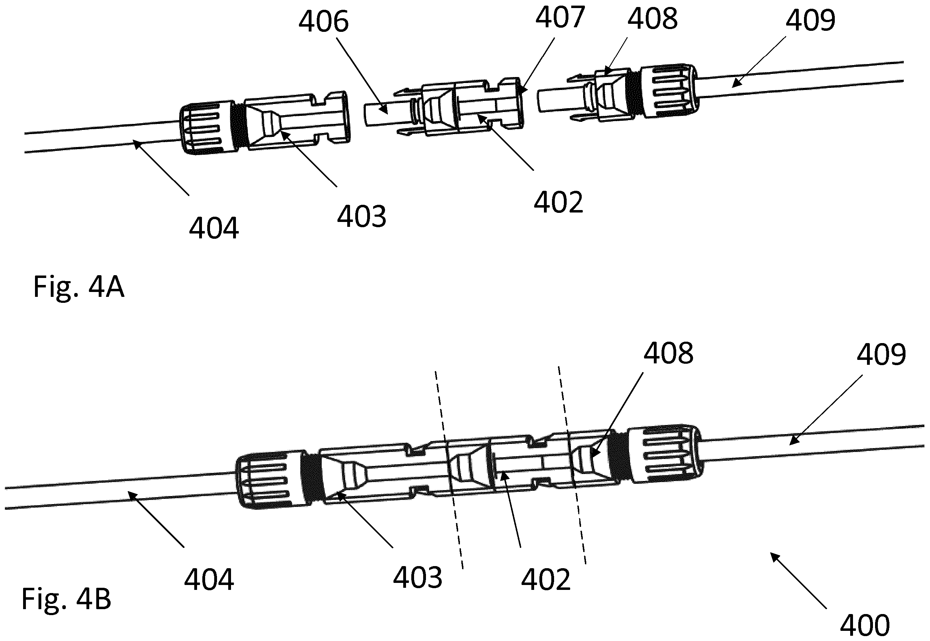

Reference is now made to Figs. 4A-4B, which illustrates the connectivity of a safety switch according to illustrative embodiments. Safety switch 402 may be similar to or the same as safety switch 302 of Fig. 3. Safety switch 402 may comprise male connector 406 for connecting to connector 403, with connector 403 connected to conductor 404 which carries power generated by a first PV generator (not explicitly depicted). Similarly, safety switch 402 may comprise female connector 407 for connecting to connector 408, with connector 408 connected to conductor 409 which carries power generated by a second PV generator (not explicitly depicted). In some conventional photovoltaic systems, the first and second photovoltaic generators may be serially connected by connecting connector 403 to connector 408. Safety switch 402 may be designed to seamlessly connect to connector 403 on one end and to connector 408 on the other end, adding safety-disconnect, control and/or monitoring features to a photovoltaic installation, either during construction of the installation or as a retrofit feature at a later time.

Fig. 4A shows safety switch 402 along with connectors 408 and 403 prior to connecting, according to illustrative embodiments, while Fig. 4B shows connection point 400 comprising safety switch 402 connected to connectors 408 and 403 (the component boundaries indicated by dashed lines).

In some embodiments not forming part of the present invention, advantages may be obtained by integrating safety switch 402 into a photovoltaic generator connector or a PV generator junction box. For example, safety switch 402 may be built into connector 403 or connector 408 of a PV generator, providing safety switching functionality in a PV generator without necessitating additional components and connections. Integrating safety switches in PV generator connectors or junction boxes may reduce costs (e.g. by not requiring a separate enclosure and connectors for the safety switch) and simplify installation (since no additional components need be connected).

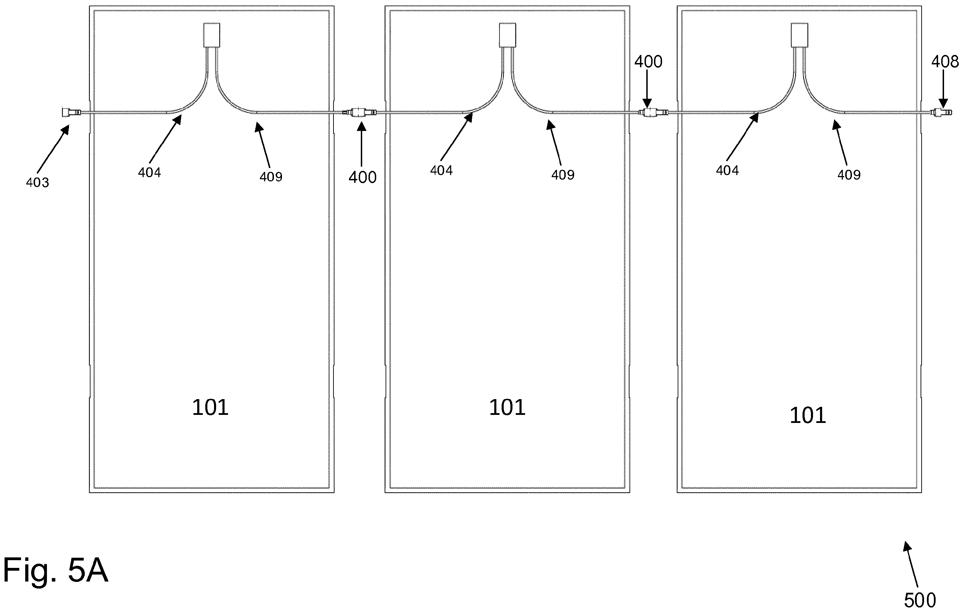

Reference is now made to Fig. 5A, which shows part of a photovoltaic (PV) string featuring a safety switch according to illustrative embodiments. PV string 500 is part of a string of PV generators 101 (e.g. part of a string similar to or the same as PV string 104 of Fig. 1A, comprising generators similar to or the same as PV generators 101 of Fig. 1A and Fig. 2) connected to each other via connection points 400. Connection points 400 may be similar to or the same as connection point 400 of Fig. 4A and Fig. 4B, and may include a safety switch (e.g. safety switch 402) coupled in between two PV generator connectors (e.g. connectors 403 and 408). Each PV generator 101 comprises conductors 404 and 409 for carrying photovoltaic power from PV cells comprising the PV generator, and connectors 403 and 408 for connecting to safety switch 402.

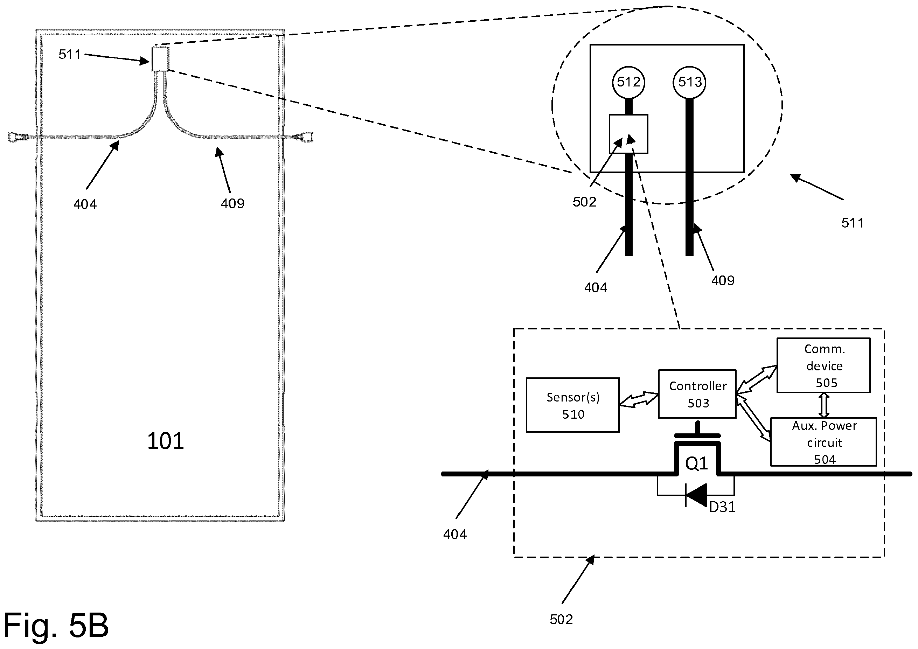

Reference is now made to Fig. 5B, which illustrates a PV generator comprising a safety switch according to illustrative embodiments that do not form part of the present invention. PV generator 101 comprises junction box 511 and conductors 404 and 409. Fig. 5B illustrates the back side on a PV generator, with PV cells mounted on the front side of the PV generator (not explicitly shown). In some embodiments, PV cells may be mounted on both sides of the PV generator, or the back side of the PV generator may be constructed to allow solar irradiance to reach the PV cells from both sides of the PV generator. Junction box 511 comprises electrical connections 512 and 513 for collecting photovoltaic power from the PV cells, and providing the photovoltaic power via conductors 409 and 404.

Safety switch 502 is disposed between conductor 404 and electrical connection 512. Safety switch 502 may be functionally similar or the same as safety switch 302 of Fig. 3, without requiring the physical enclosure and male and female connectors 306 and 307. Transistor Q1, diode D31, sensor(s)/sensor interfaces 510, controller 503, communication device 505 and/or auxiliary power circuit 504 may be integrated in junction box 511. A resistor may be coupled across the terminals of transistor Q1 (similarly to resistor R31 of Fig. 3) for regulating the OFF-state current through safety switch 502. Auxiliary power circuit 504 is coupled between conductors 404 and 409 for receiving photovoltaic power generated by PV generator 101, and provides power to controller 503, and may provide power to communication device 505 and/or sensor(s)/sensor interfaces 510.

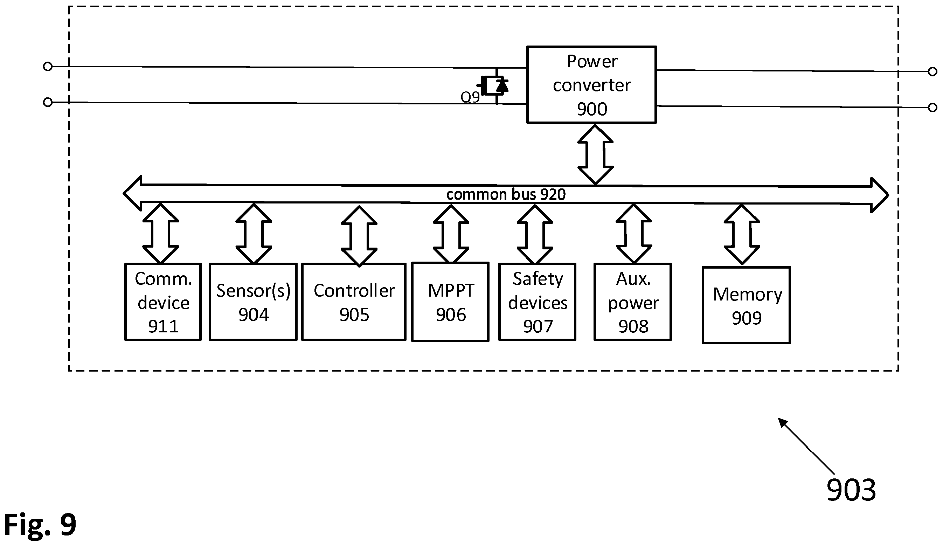

Junction box 511 may further include an integrated PV power device similar to or the same as PV power device 903 of Fig. 9. PV power device 903 may be coupled between conductors 404 and 409 and electrical connections 512 and 513. For example, power converter 900 of Fig. 9 may receive power from electrical connections 512 and 513, and may output power to conductors 404 and 409. Safety switch 502 may be disposed between PV power device 903 and electrical connection 512, or, in some embodiments, may be integrated into PV power device 903.

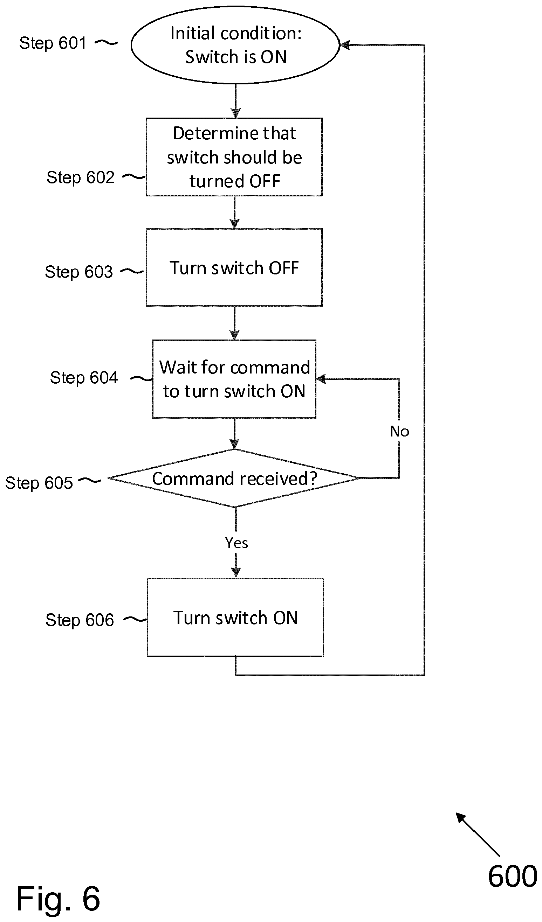

Reference is now made to Fig. 6, which shows a method for operating a safety switch (e.g. safety switch 102 of Fig. 1A, safety switch 302 of Fig. 3). Method 600 may be carried out by a controller similar to or the same as controller 303 of Fig. 3. At step 601, the initial condition is that the switch is in the ON state, allowing current to flow between the two conductors coupled to the switch (e.g. conductors 404 and 409 of Fig. 5A). During step 601, an auxiliary power circuit coupled to the safety switch provides power to the controller and/or a gate driver for maintaining the switch in the ON state (for example, some types of transistors implementing safety switches may be "normally OFF", in which case the auxiliary power circuit may power a voltage signal applied to a transistor gate node to maintain the ON state). At step 602, the controller receives a command to turn the switch to the OFF state. In some embodiments, the command is received via a communication device (e.g. communication device 305) in communication with a system control device. In some embodiments, at step 602, instead of receiving a command to turn the switch to the OFF state, the controller independently determines that an unsafe condition is be present (e.g. due to sensor reporting high current or temperature, or a sensor detecting a rapid change in current flowing through the switch, or based on comparing two electrical parameters and detecting a substantial mismatch) and determine that the switch should be turned to the OFF state. In some embodiments, a determination that the switch should be turned to the OFF state is made in response to not receiving a signal. For example, in some illustrative systems, a system control device continuously provides a "keep alive" signal to associated safety switches and PV power devices. Not receiving a "keep alive" signal may indicate a potentially unsafe condition and may cause a determination that the switch should be turned to the OFF state.

Still referring to Fig. 6, at step 603, the controller turns the switch to the OFF state. In some embodiments (e.g. if the switch is a "normally ON" transistor), turning the switch to the OFF state includes applying a voltage to a transistor terminal, and in some embodiments (e.g. if the switch is a "normally OFF" transistor), turning the switch to the OFF state includes ceasing to apply a voltage to a transistor terminal. At step 604, the controller waits to receive a command to turn the switch back to the ON position. Generally, once an unsafe condition has been resolved, a system control device may provide a signal indicating that it is safe to reconnect PV generators and to resume providing power. In some embodiments, at step 604 the controller independently determines that it is safe to return the switch to the ON position (e.g., due to a sensor reporting that the unsafe condition is no longer present).

At step 605, the controller determines if a command (or, in some embodiments, a self-determination) to turn the switch to the ON state has been received. If no such command (or determination) has been received, the controller carrying out method 600 returns to step 604. If a command (or, in some embodiments, a self-determination) to turn the switch to the ON state has been received, the controller carrying out method 600 proceeds to step 606, turns the switch back to the ON state (e.g. by applying a voltage to a transistor node, or removing an applied voltage from a transistor node) and returns to step 601.

An auxiliary circuit for providing continuous power supply to a safety switch according to embodiments disclosed herein may be variously implemented. Auxiliary power circuits may provide power for operating a safety switch under varying conditions and at various times. For example, auxiliary power circuits may provide operational power to a safety switch at three times: at initial startup (i.e. when the system comprising a safety switch is first deployed), at steady-state ON time (i.e. when the system is up and running, during normal operating conditions, when the switch is ON), and at steady-state OFF time (i.e. when the system is up and running, during a potentially unsafe condition, when the switch is OFF).

Reference is now made to Fig. 7A, which illustrates a safety switch 702a comprising an auxiliary power circuit according to illustrative embodiments. Safety switch 702a comprises conductors 708 and 709, transistor Q1, controller 710 and auxiliary power circuit 704. Safety switch 702a may further comprise a communication device similar to or the same as communication device 305 of Fig. 3 (not explicitly depicted, to reduce visual noise). Transistor Q1 may be similar to or the same as transistor Q1 described with regard to Fig. 3, resistor R31 may be the same as R31 of Fig. 3, diode D31 may be the same as D31 of Fig. 3, controller 710 may be similar to or the same as controller 303 of Fig. 3, and conductors 708 and 709 may be similar to or the same as conductors 308 and 309, respectively, of Fig. 3.

Auxiliary power circuit 704 is coupled in parallel to transistor Q1. A first input of auxiliary power circuit 704 is coupled to conductor 708, and a second input of auxiliary power circuit 704 is coupled to conductor 709.

In some embodiments, auxiliary power circuit 704 comprises analog circuitry configured to provide an appropriate control signal to transistor Q1. Auxiliary power circuit 704 provides power to controller 710, with controller 710 configured to provide a control signal to transistor Q1.

Reference is now made to Fig. 7B, which illustrates a safety switch 702b comprises an auxiliary power circuit according to illustrative embodiments, not forming part of the present invention. Safety switch 702b comprises conductors 708 and 709, transistor Q1, controller 710 and auxiliary power circuit 714. Safety switch 702b may further comprise a communication device similar to or the same as communication device 305 of Fig. 3 (not explicitly depicted, to reduce visual noise). Transistor Q1 may be similar to or the same as transistor Q1 described with regard to Fig. 3, resistor R31 may be the same as R31 of Fig. 3, diode D31 may be the same as D31 of Fig. 3, controller 710 may be similar to or the same as controller 303 of Fig. 3, and conductors 708 and 709 may be similar to or the same as conductors 308 and 309, respectively, of Fig. 3.

Auxiliary power circuit 714 is coupled in series with transistor Q1. A first input of auxiliary power circuit 714 is coupled to conductor 708, and a second input of auxiliary power circuit 704a is coupled to transistor Q1.

Reference is now made to Fig. 7C, which depicts an auxiliary power circuit according to illustrative embodiments. Auxiliary power circuit 704a may be used as auxiliary power circuit 704 of Fig. 7A. A first input to auxiliary power circuit 704a is coupled to the source terminal of a transistor (e.g. Q1 of Fig. 7A), and a second input to auxiliary power circuit 704a is coupled to the drain terminal of a transistor. An output of auxiliary power circuit 704a is coupled to the gate terminal of a transistor. Auxiliary power circuit 704a comprises Ultra Low Voltage Direct-Current to Direct Current (DC/DC) converter (ULVC) 720. Controller 710 may be an analog or digital controller, and may be similar to controller 303 of Fig. 3. Controller 710 may be integrated with or separate from auxiliary power circuit 304a. In some embodiments, an output of ULVC 720 may be coupled to an input of controller 710, with controller 710 applying a voltage to the gate of a transistor. ULVC 720 may be configured to receive a very low voltage (e.g. tens or hundreds of millivolts) at its input, and output a substantially larger voltage (e.g. several volts). ULVC 720 may be variously implemented. In some embodiments, ULVC may comprise an oscillator charge pump and/or several conversion stages. Variations of illustrative circuits found in "0.18-V Input Charge Pump with Forward Body Biasing in Startup Circuit using 65nm CMOS" (P.H. Chen et. al., ^{©}IEEE 2010), "Low voltage integrated charge pump circuits for energy harvesting applications" (W.P.M. Randhika Pathirana, 2014) may be used as or as part of ULVC 720.

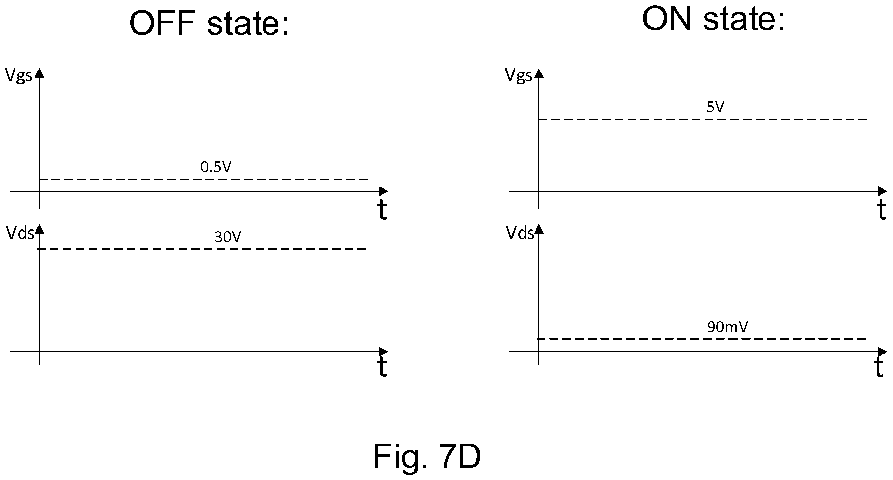

Reference is now made to Fig. 7D, which shows a timing diagram for operating auxiliary power circuit 704a of Fig. 7C according to an illustrative embodiment. As a numerical example, auxiliary power circuit 704a may be coupled as described above to the terminals of a MOSFET. ULVC 720 may be coupled between the source (Vs) and drain (Vd) terminals of the MOSFET. When the MOSFET is in the OFF position, the voltage drop between terminals Vs and Vd may be substantial, e.g. close to the open-circuit voltage of a PV generator. When the MOSFET is in the OFF position, ULVC 720 may be bypassed or disabled, with the substantial voltage drop between terminals Vs and Vd processed to provide power to controller 710. Controller 710 may hold the voltage between the MOSFET gate and source terminals to a low value, (e.g. 0V or 1V, under a minimum source-gate threshold of 2V), maintaining the MOSFET in the OFF position.

Still referring to Fig. 7D, controller 710 may receive a command via a communication circuit (not explicitly depicted) to turn the MOSFET to the ON state. Controller 710 may increase the gate-to-source voltage to about 5V. In illustrative PV systems, the current flowing through a PV string at certain points of operation may be about 10A. At a gate-to-source voltage of 5V and drain-to-source current of 10A, the drain-to-source voltage may be about 90mV. ULVC 720 may boost the drain-to-source voltage of 90mV to a voltage of several volts or more (e.g. 5V, 10V, 12V or 20V) for powering controller 710. Controller 710 may continuously hold the gate-to-source voltage at about 5V until a command is received to turn the MOSFET OFF. In some embodiments, the MOSFET is turned OFF at the end of every day, i.e. when PV generators cease producing significant power due to nightfall. When it is time to turn the MOSFET OFF, controller may decrease the gate-to-source voltage back to about 0V or 1V.

Operating auxiliary power circuit 704a according to the illustrative timing diagrams of Fig. 7D may provide several advantages. For example, the steady-state power consumed by safety switch 702a using auxiliary power circuit 704a may be low, in this illustrative example, 90mV ^{∗} 10A = 900mW when in the ON position, and 30V ^{∗} 10uA = 0.3mW when in the OFF position. Furthermore, the steady-state voltage across safety switch 702a may be substantially constant when in the ON position (e.g. 90mV).

Reference is now made to Fig. 7E, which depicts an auxiliary power circuit according to illustrative embodiments. Auxiliary power circuit 704b may be used as auxiliary power circuit 704 of Fig. 7A. A first input to auxiliary power circuit 704b is coupled to the source terminal of a transistor (e.g. Q1 of Fig. 7A), and a second input to auxiliary power circuit 704b is coupled to the drain terminal of a transistor. An output of auxiliary power circuit 704b is coupled to the gate terminal of a transistor. Auxiliary power circuit 704b comprises capacitor C2, diode D2, diode Z2, transistor Q70 and DC-to-DC converter 721. In some embodiments, capacitor C2 is replaced by a different charge device (e.g. a battery). Controller 710 may be analog or digital, and may be similar to controller 303 of Fig. 3. Controller 710 may be integrated with or separate from auxiliary power circuit 304a. Diode Z2 may be a Zener diode designed to limit and hold a reverse-bias voltage to a predetermined value. In this illustrative embodiment, diode Z2 is assumed to have a reverse-bias voltage of 4V. A first input to auxiliary power circuit 704b is coupled to the source terminal of a transistor (e.g. Q1 of Fig. 7A), and a second input to auxiliary power circuit 704b is coupled to the drain terminal of a transistor (e.g. Q1). An output of auxiliary power circuit 704b is coupled to the gate terminal of a transistor (e.g. Q1). In some embodiments, an output of converter 721 is coupled to an input of controller 710, with controller 710 applying a voltage to the gate of a transistor. Converter 721 may be configured to receive a voltage of several volts (e.g. between 3V-10V) at its input, and output a voltage for powering controller 710 or controlling the gate voltage of a transistor gate terminal.

The anode of diode D2 is coupled to a transistor drain terminal (Vd), and the cathode of diode D2 is coupled to the cathode of diode Z2 and a first terminal of capacitor C2. The anode of diode Z2 is coupled to a drain terminal of transistor Q70, with the source terminal of transistor Q70 coupled to a transistor source terminal (Vs) and to a second terminal of capacitor C2. The gate voltage of transistor Q70 is controlled by controller 710 (the control line is not explicitly depicted). The inputs of converter 721 is coupled in parallel with capacitor C2.

Auxiliary power circuits 704a-b and 714 may be operated to provide a voltage drop across the terminals of safety switch 702 according to safety and effective system operation requirements. The drain-to-source voltage may be desired to be low during normal system operation, when safety switch 702 is in the "steady ON state", i.e. when the switch provides a low-impedance path for photovoltaic power to flow through a PV string. When safety switch 702 is in a "steady OFF state", safety switch 702 may be required to provide a drain-to-source voltage of about an open-circuit voltage of a PV generator without providing a low-impedance path for current flow.

Referring back to Fig. 7E, controller 710 may operate transistor Q70 and transistor Q1 of Fig. 7A to provide a voltage drop across the terminals of safety switch 702 according to safety and effective system operation requirements. In the "steady OFF state", transistors Q1 and Q70 may be held in the OFF state. In the "steady ON state" transistor Q1 may be ON, providing a low impedance path between the drain and source terminals, and transistor Q70 may be either ON or OFF. It may be desirable during the "steady ON state" to temporarily move Q1 to the "temporarily OFF state" for a short period of time, to allow capacitor C2 to recharge and continue providing operational power to controller 710. In the "temporarily OFF" state, transistor Q1 may be OFF and transistor Q70 may be ON. Diode Z2 may provide a limited charging voltage (e.g. 4V) across the terminals of capacitor C2, with capacitor C2 providing a current path for the current of a PV string.

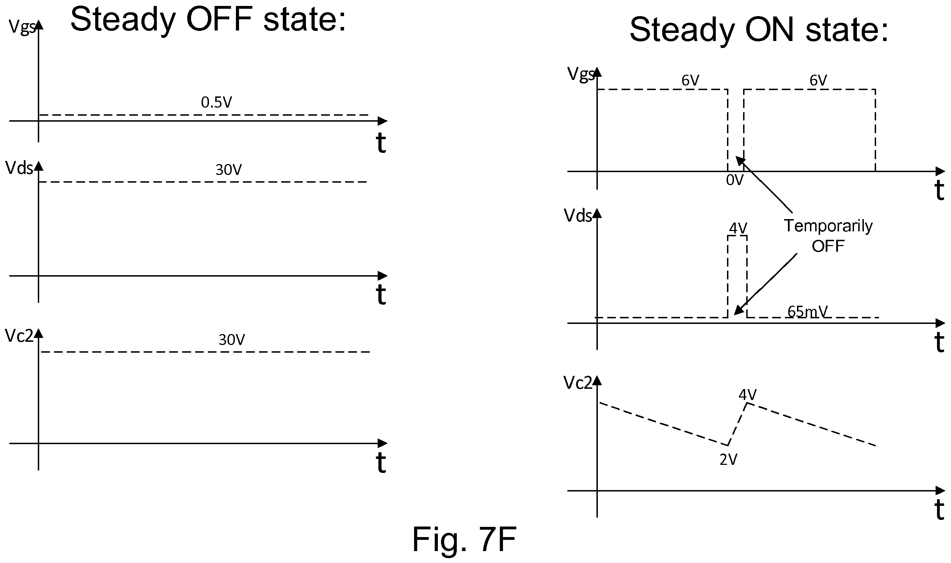

Reference is now made to Fig. 7F, which shows a timing diagram for operating auxiliary power circuit 704b of Fig. 7E according to an illustrative embodiment. As a numerical example, auxiliary power circuit 704a is coupled as described above to the terminals of a MOSFET. Converter 721 may be coupled between the source (Vs) and drain (Vd) terminals of the MOSFET. When the MOSFET is in the steady-OFF-state, the voltage drop between terminals Vs and Vd may be substantial, e.g. close to the open-circuit voltage of a PV generator. When the MOSFET is in the steady-OFF-state, converter 721 may be bypassed or disabled, with the substantial voltage drop between terminals Vs and Vd processed to provide power to controller 710. In some embodiments, when the MOSFET is in the steady-OFF-state, converter 721 may process the drain-to-source voltage to provide power to controller 710. Controller 710 may hold the voltage between the MOSFET gate terminal and source terminals to a low value, (e.g. 0V or 1V, under a minimum source-gate threshold of 2V), maintaining the MOSFET in the OFF position. When the MOSFET is in the steady-OFF-state, capacitor C2 may be charged to about the voltage between the drain and source terminals. In some embodiments, diode Z2 is disconnected (e.g. by turning Q70 to the OFF state), to increase the drain-to-source voltage when the MOSFET is in the steady-OFF-state. In some embodiments, having a large drain-to-source voltage (e.g. about the same voltage as a PV generator open-circuit voltage) when the MOSFET is in the steady-OFF-state increases system safety by decreasing the total voltage across a PV generator and an accompanying safety switch.

Still referring to Fig. 7F, controller 710 may receive a command via a communication circuit (not explicitly depicted) to turn the MOSFET to the ON state. Controller 710 may increase the gate-to-source voltage of Q1 to about 6V. In illustrative PV systems, the current flowing through a PV string at certain points of operation may be about 10A. At a gate-to-source voltage of 6V and drain-to-source current of 10A, the drain-to-source voltage may be about 65mV. Diode D2 might not be forward biased (e.g., if diode has a forward voltage of 0.6V, a drain-to-source voltage of 65mV might not forward-bias diode D2), disconnecting capacitor C2 from the drain terminal. Capacitor C2 may slowly discharge by providing power to converter 721. Converter 721 may include circuitry (e.g. analog comparators) to monitor the voltage across capacitor C2, and may respond to the voltage across capacitor C2 falling below a first threshold. If the voltage across capacitor falls below the first threshold, controller 710 may reduce the gate-to-source voltage to about 0V or 1V, resulting in the MOSFET moving to the OFF state. Diode D2 may then become forward-biased, and diode Z2 may limit the drain-to-source voltage to a second threshold. Transistor Q70 may be held in the ON state, allowing diode Z2 to regulate the drain-to-source voltage. Capacitor C2 may then be rapidly charged back to about the voltage level of the second threshold, with controller 710 configured to increase the gate-to-source voltage back to 6V when capacitor C2 reaches the second threshold voltage. This iterative process may repeat itself while the MOSFET is operating in a "steady ON state" mode. In the illustrative embodiment illustrated in Fig. 7F, the first threshold is 2V, and the second threshold is 4V. The voltage across capacitor C2 varies between the two levels, with the gate-to-source voltage alternating between about 0V and about 6V, and the drain-to-source voltage alternating between 4V and 65mV.

Operating auxiliary power circuit 704b according to the illustrative timing diagrams of Fig. 7F may provide several advantages. For example, a converter designed to receive an input voltage between 2 - 30V (e.g. converter 721) may be cheap, efficient and easy to implement. In some embodiments, one or more additional Zener diodes may be coupled in series with diode Z2, increasing the first voltages. Increasing the first threshold voltage (e.g. to 10V, 15V or 20V, respectively) may provide advantages such as decreasing the frequency of charge-discharge cycles over capacitor C2, and may provide a voltage to converter 721 which may be easier to process.

It is to be understood that illustrative operating points comprising MOSFET drain-to-source voltages of 65mV and 90mV, MOSFET gate-to-source voltages of 5V and 6V, and MOSFET drain-to-source currents of 10A are used for illustrative purposes and are not intended to be limiting of operating points used in conjunction with illustrative embodiments disclosed herein. In some embodiments, multiple MOSFET transistors may be parallel-coupled to reduce ON-state resistance, thereby reducing the drain-to-source voltage across MOSFETs when in the ON state. For example, coupling five MOSFETs in parallel may reduce a drain-to-source ON-state voltage from 65mV to 15mV.

Reference is now made to Fig. 7G, which depicts an auxiliary power circuit according to illustrative embodiments. Auxiliary power circuit 704c may be used as auxiliary power circuit 704 of Fig. 7A. Auxiliary power circuit 704c may be similar to auxiliary power circuit 704b, with a modification in that the anode of diode Z2 is coupled to the drain terminal of transistor Q1 (Vs), and that the drain terminal of transistor Q70 is also coupled to the source terminal of transistor Q1 (Vs). When safety switch 702 is in the "steady ON state", transistors Q1 and Q70 may be ON, providing a low impedance path for PV string current. When safety switch 702 is in the "steady OFF state", transistors Q1 and Q70 may be OFF, preventing a low impedance path for a PV string current, and providing a substantial voltage drop across the terminals of safety switch 702 (e.g. about the same voltage or a slightly lower voltage than a PV-generator open-circuit voltage). When safety switch 702 is in the "temporarily OFF state", transistor Q1 may be OFF and transistor Q70 may be ON, diode Z2 providing a charging voltage to capacitor C2 and Q70 providing a low-impedance current path for a PV string current.

Reference is now made to Fig. 7H, which illustrates a safety switch comprising an auxiliary power circuit according to illustrative embodiments, not forming part of the present invention. Safety switch 702c comprises conductors 708 and 709, transistor Q1, controller 710 and auxiliary power circuit 715. Auxiliary power circuit 715 may be used auxiliary power circuit 714 of Fig. 7B. In this illustrative embodiment, auxiliary power circuit 715 may double as a power line communication (PLC) device. Inductor L4, capacitor C3 and resistor **R** may be coupled in parallel, with a first node of inductor L4 coupled to conductor 708, and a second node of inductor L4 coupled to the source terminal of transistor Q1. The values of inductor L4 and capacitor C3 may be selected to resonate at a resonant frequency (e.g. 60kHz).

Still referring to Fig. 7H, an external device (e.g. system power device 110 of Fig. 1) may transmit a PLC high-frequency alternating current signal (e.g. using frequency shift keying, amplitude modulation or other modulation schemes) over conductor 708. The PLC signal may induce a high-frequency alternating-current voltage drop across the terminals of resistor **R,** with diode D7 providing a voltage to controller 710 when the voltage across resistor **R** is positive (i.e. the voltage at conductor 708 is higher than the voltage at the source terminal of transistor Q1). In some embodiments, diode D7 may be replaced by a "full bridge" of diodes providing a voltage to controller 710 when the voltage across **R** is nonzero (either positive or negative). In some embodiments, the PLC-induced voltage across resistor R serves a dual purpose. The PLC signal may provide operational information to controller 710 by varying the voltage drop across resistor **R.** Additionally, in some embodiments, the PLC signal may provide operational power to controller 710. Controller 710 may draw power from the resonant circuit comprising resistor **R,** capacitor C3 and inductor L4, and use the drawn power to set the state of transistor Q1.

Implementing auxiliary power circuit 715 as illustrated in Fig. 7H may provide certain advantages. For example, auxiliary power circuit 715 of Fig. 7H may double as a communication device, reducing the total component count in safety switch 702c. Furthermore, integrating control and power signals may reduce the complexity required to program controller 710. For example, an 'ON' signal may be broadcast by a system controller at a high power, and an 'OFF' signal may be broadcast by a system controller at low power. Auxiliary power circuit 715 may directly apply the converted power signal to the gate of transistor Q1, wherein the power of the 'ON' signal may be sufficient to hold Q1 in the ON state, and the power of the 'OFF' signal might not be sufficient to hold Q1 in the ON state.

Elements of auxiliary power circuits 704a, 704b and 715 may be variously combined. For example, auxiliary power circuit 714 of Fig. 7B may be added to safety switch 702a of Fig. 7A, auxiliary power circuit 714 functioning as a PLC circuit as well as being configured to provide power to controller 710 in case of a malfunction in auxiliary power circuit 704. In some embodiments, auxiliary power circuit 714 may provide initial power to controller 710 at system setup, with auxiliary power circuit 704 providing power to controller 710 during "steady state" operation.

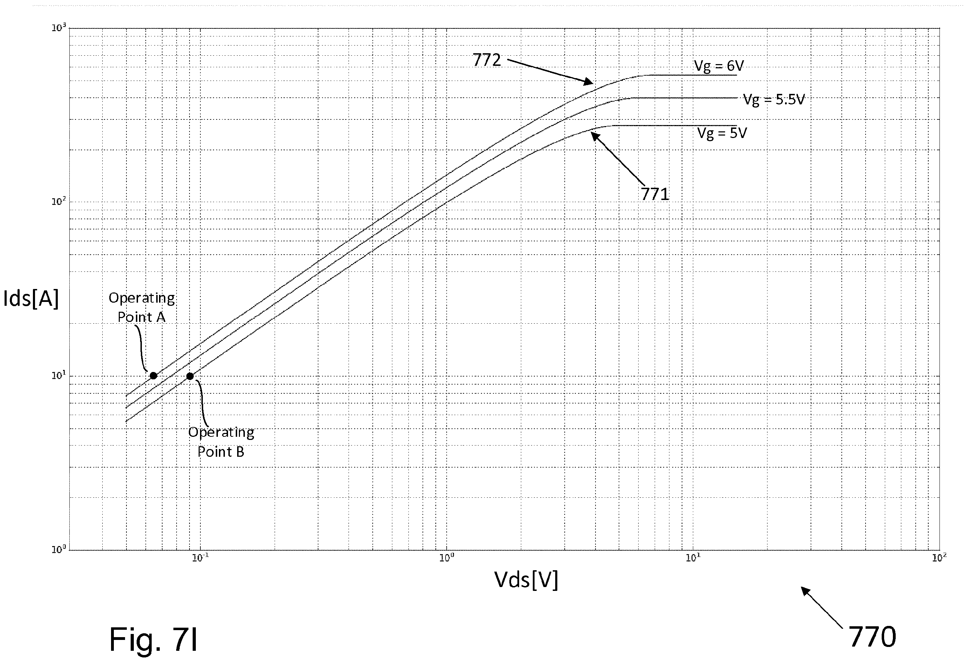

Reference is now made to Fig. 7I, which illustrates part of a MOSFET datasheet according to an illustrative embodiment. Plot 770 may depict relationships between drain-to-source voltage and drain-to-source current through a MOSFET. Curve 771 may depict a current-voltage relationship when the gate-to-source voltage applied to a MOSFET is 5V. Curve 771 may depict a current-voltage relationship when the gate-to-source voltage applied to a MOSFET is 6V. Operating point A may indicate that when a gate-to-source voltage applied to a MOSFET is 6V and the drain-to-source current flowing through the MOSFET is 10A, the drain-to-source voltage across the MOSFET is about 65mV. This may correspond to a possible operating point for a MOSFET operated according to Fig. 7F. Operating point B may indicate that when a gate-to-source voltage applied to a MOSFET is 5V and the drain-to-source current flowing through the MOSFET is 10A, the drain-to-source voltage across the MOSFET is about 90mV. This may correspond to a possible operating point for a MOSFET operated according to Fig. 7D. As noted above, these operating points are illustrative only, and may adapted by connected multiple MOSFETs in parallel to obtain new operating points.

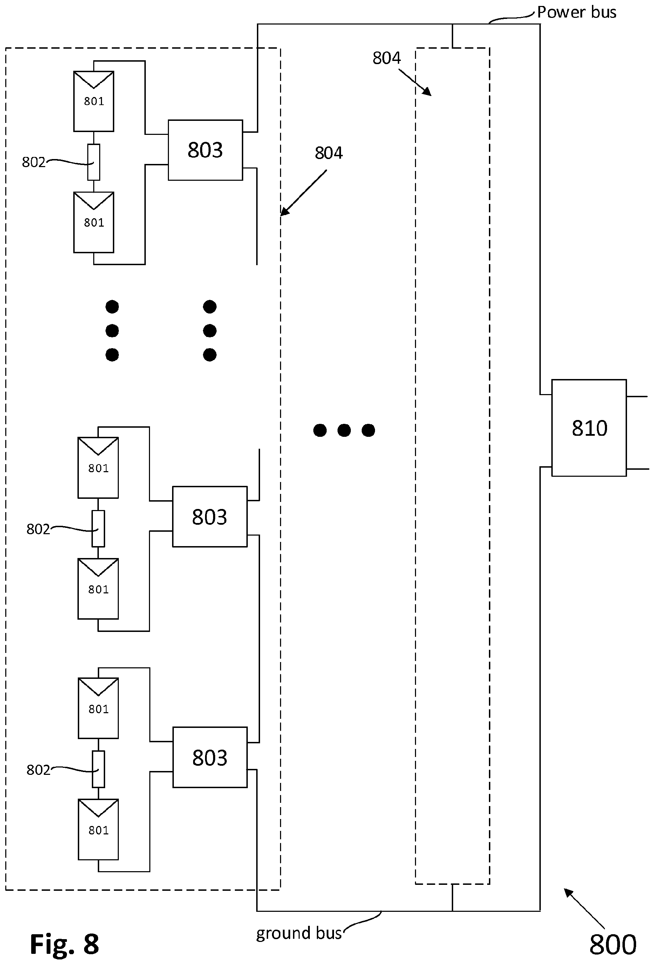

Reference is now made to Fig. 8, which shows a photovoltaic (PV) system according to illustrative embodiments. PV system 800 may comprise a plurality of PV strings 804 coupled in parallel between a ground bus and a power bus. Each of PV strings 804 may comprise a plurality of photovoltaic generators 801, a plurality of safety switches 802 and a plurality of PV power devices 803. PV generators 801 may be similar to or the same as PV generators 101 of Fig. 1A, and safety switches 802 may be similar to or the same as safety switch 102 of Fig. 1A, safety switch 302 of Fig. 3 and/or safety switches 702a-702c of Figs. 7A-7C.

In some embodiments, the power and ground buses may be input to system power device 810. In some embodiments, system power device 810 may include a DC/AC inverter and may output alternating current (AC) power to a power grid, home or other destinations. In some embodiments, system power device 810 may comprise a combiner box, transformer and/or safety disconnect circuit. For example, system power device 810 may comprise a DC combiner box for receiving DC power from a plurality of PV strings 804 and outputting the combined DC power. In some embodiments, system power device 810 may include a fuse coupled to each PV string 804 for overcurrent protection, and/or one or more disconnect switches for disconnecting one or more PV strings 804. In some embodiments, system power device 810 may comprise a system controller (e.g. an analog control circuit, a microcontroller, a Digital Signal Processor (DSP), Application-Specific Integrated Circuit (ASIC) and/or a Field Programmable Gate Array (FPGA)) for providing commands to and receiving data from PV power devices 803 and safety switches 802.

Each safety switch 802 may be coupled between a first output of a first PV generator and a second output of a second output generator, and each PV power device may have two input terminals: a first input terminal coupled to the second output of the first PV generator, and a second input terminal coupled to the first output of the second PV generator. In this "two-to-one" arrangement, each pair of PV generators 801 are effectively coupled in series, with the combined voltage and power of the two PV generators provided to the input of PV power device 803. Each safety switch 802 is disposed between the two PV generators, for disconnecting the pair of PV generators in case of a potentially unsafe condition.

Some conventional PV installations feature a similar arrangement, with each pair of PV generators 801 directly connected to each other without a safety switch disposed in between the generators. In case of an unsafe condition, a PV power device 803 may stop drawing power from the PV generators, resulting in an open-circuit voltage at the PV power device input terminals which is about double the open-circuit voltage of each PV power generator. This voltage may, in some systems, be as high as 80, 100 or even 120 volts, which may be higher than the allowed safe voltage defined by safety regulations.

By operating safety switches 802 according to apparatuses and methods disclosed herein, in case of an unsafe condition (e.g. detected by system power device 810, a PV power device 803 and/or a safety switch 802), one or more safety switches 802 may move to the OFF state, reducing the voltage drop between the input terminals of each PV power device 803 to about 40-60 volts, which may be an adequately safe voltage level.

Each PV power device 803 may receive power from two photovoltaic generators 801 coupled to the inputs of PV power device 803, and may provide the combined power of the two photovoltaic generators at the outputs of PV power device 803. The outputs of a plurality of PV power devices 803 may be coupled in series to form a PV string 804, with a plurality of PV strings 804 coupled in parallel to provide power to system power device 810.

While Fig. 8 illustrates an arrangement wherein two PV generators 801 are coupled in parallel to each PV power device 803, various arrangements can be easily obtained. For example, each PV power device receive power from three or more serially-connected PV generators 801, with safety switches 802 disposed between the PV generators. In some embodiments, some PV power devices 803 may receive power from a single PV generator 801, some PV power devices may receive power from two PV generators 801, and some PV power devices may receive power from more than two PV generators 801. In some embodiments, PV power devices 803 may receive power from multiple parallel-connected serial strings of PV generators 801, with safety switches 802 disposed in the serial strings. Embodiments disclosed herein include the aforementioned modifications, and other modifications which will be evident to one of ordinary skill in the art.

Reference is now made to Fig. 9, which illustrates circuitry which may be found in a power device such as PV power device 903, according to an illustrative embodiment. PV power device 903 may be similar to or the same as PV power device 803 of Fig. 8. In some embodiments, PV power device 903 may include power converter 900. Power converter 900 may comprise a direct current-direct current (DC/DC) converter such as a Buck, Boost, Buck/Boost, Buck + Boost, Cuk, Flyback and/or forward converter. In some embodiments, power converter 900 may comprise a direct current - alternating current (DC/AC) converter (also known as an inverter), such a micro-inverter. Power converter 900 may have two input terminals and two output terminals, which may be the same as the input terminals and output terminals of PV power device 903. In some embodiments, PV power device 903 may include Maximum Power Point Tracking (MPPT) circuit 906, configured to extract increased power from a power source the power device is coupled to. According to some aspects of the disclosure herein, power converter 900 may include MPPT functionality. In some embodiments, MPPT circuit 906 may implement impedance matching algorithms to extract increased power from a power source the power device is coupled to. PV power device 903 may further comprise controller 905 such as a microprocessor, Digital Signal Processor (DSP), Application-Specific Integrated Circuit (ASIC) and/or a Field Programmable Gate Array (FPGA).

Still referring to Fig. 9, controller 905 may control and/or communicate with other elements of PV power device 903 over common bus 920. According to features of the disclosure herein, PV power device 903 may include circuitry and/or sensors/sensor interfaces 904 configured to measure parameters directly or receive measured parameters from connected sensors and/or sensor interfaces 904 configured to measure parameters on or near the power source, such as the voltage and/or current output by the power source and/or the power output by the power source. In some embodiments the power source may be a PV generator comprising PV cells, and a sensor or sensor interface may directly measure or receive measurements of the irradiance received by the PV cells, and/or the temperature on or near the PV generator.

Still referring to Fig. 9, according to aspects of the disclosure herein, PV power device 903 may include communication device 911, configured to transmit and/or receive data and/or commands from other devices. Communication device 911 may communicate using Power Line Communication (PLC) technology, or wireless technologies such as ZigBee^{™}, Wi-Fi, cellular communication or other wireless methods.. In some embodiments, PV power device 903 may include memory device 909, for logging measurements taken by sensor(s)/sensor interfaces 904 to store code, operational protocols or other operating information. Memory device 909 may be flash, Electrically Erasable Programmable Read-Only Memory (EEPROM), Random Access Memory (RAM), Solid State Devices (SSD) or other types of appropriate memory devices.

Still referring to Fig. 9, in some embodiments, PV power device 903 may include safety devices 907 (e.g. fuses, circuit breakers and Residual Current Detectors). Safety devices 907 may be passive or active. For example, safety devices 907 may comprise one or more passive fuses disposed within PV power device 903 and designed to melt when a certain current flows through it, disconnecting part of PV power device 903 to avoid damage. In some embodiments, safety devices 907 may comprise active disconnect switches, configured to receive commands from a controller (e.g. controller 905, or an external controller) to disconnect portions of PV power device 903, or configured to disconnect portions of PV power device 903 in response to a measurement measured by a sensor (e.g. a measurement measured or obtained by sensors/sensor interfaces 904). In some embodiments, PV power device 903 may comprise auxiliary power circuit 908, configured to receive power from a power source coupled to PV power device 903, and output power suitable for operating other circuitry components (e.g. controller 905, communication device 911, etc.). Communication, electrical coupling and/or data-sharing between the various components of PV power device 903 may be carried out over common bus 920.

Still referring to Fig. 9, in some embodiments, PV power device 903 may comprise transistor Q9 coupled between the inputs of power converter 900. Transistor Q9 may be controlled by controller 905. If an unsafe condition is detected, controller 905 may set transistor Q9 to ON, short-circuiting the input to power converter 900. Transistor Q9 may be controlled in conjunction with safety switch 802 of Fig. 8. When safety switch 802 and transistor Q9 are OFF, each pair of PV generators 801 of Fig. 8 are disconnected, each PV generator providing an open-circuit voltage at its output terminals. When safety switch 802 and transistor Q9 are ON, each pair of PV generators 801 of Fig. 8 are connected and short-circuited, the pair of PV generators providing a voltage of about zero to power converter 900. In both scenarios, a safe voltage at all system locations may be maintained, and the two scenarios may be staggered to alternate between open-circuiting and short-circuiting PV generators. This mode of operation may allow continuous power supply to system control devices, as well as provide backup mechanisms for maintaining a safe voltage (i.e. in case a safety switch 802 malfunctions, operation of transistor Q9 may allow continued safe operating conditions).

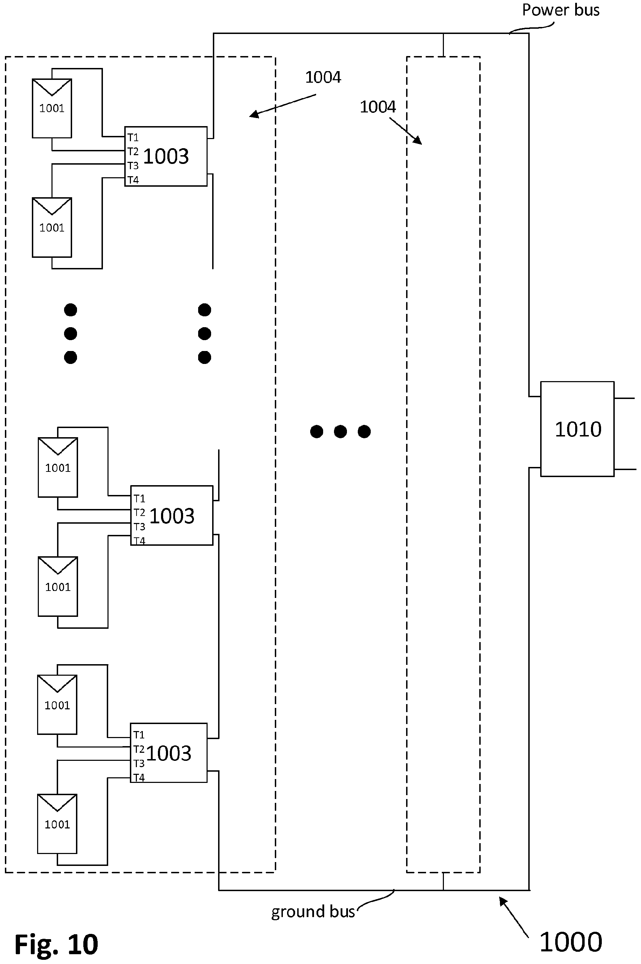

Reference is now made to Fig. 10, which shows a photovoltaic (PV) system according to illustrative embodiments. PV system 1000 may comprise a plurality of PV strings 1004 coupled in parallel between a ground bus and a power bus. Each of PV strings 1004 may comprise a plurality of photovoltaic generators 1001 and a plurality of PV power devices 1003. PV generators 1001 may be similar to or the same as PV generators 801 of Fig. 8. In some embodiments, the power and ground buses may be input to system power device 1010, which may be similar to or the same as system power device 810 of Fig. 8.

Each of photovoltaic power devices 1003 may comprise four input terminals: T1, T2, T3 and T4. T1 and T2 may be coupled to and receive power from a first PV generator, and T3 and T4 may be coupled to and receive power from a second PV generator. In some embodiments, PV power device 1003 may be substantially the same as PV power device 803 of Fig. 8, with the addition of safety switch 802 integrated into PV power device 1003 and connected in between terminals T2 and T3 of PV power device 1003.

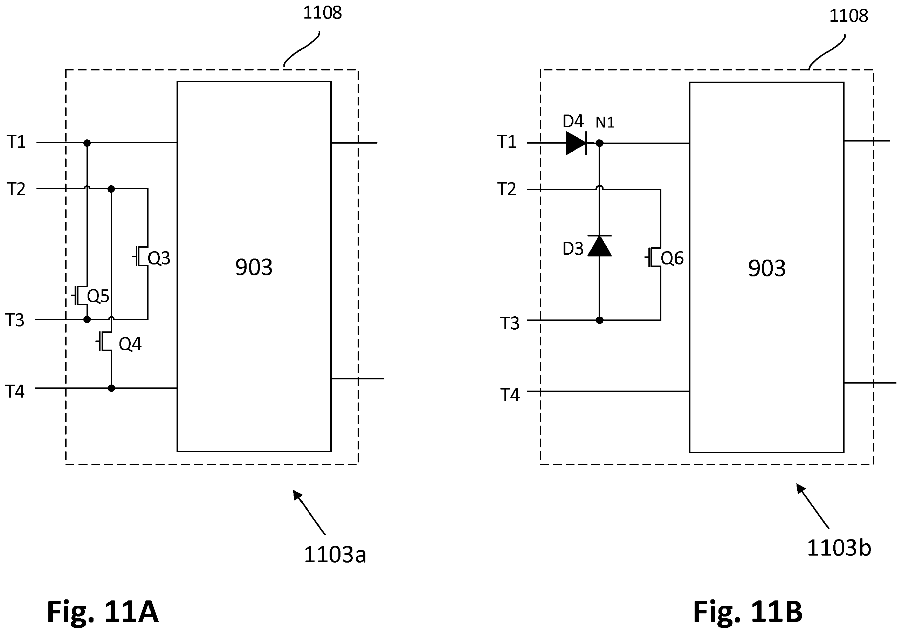

Reference is now made to Fig. 11A, which shows a photovoltaic power device according to illustrative embodiments. PV power device 1103a may be used as PV power device 1003 of Fig. 10. PV power device 1103a may comprise a PV power device similar to or the same as PV power device 803 of Fig. 8 or PV power device 903 of Fig. 9. For convenience, in the illustrative embodiments of Fig. 11A and Fig. 11B, PV power device 1103a will be assumed to comprise PV power device 903 of Fig. 9.

PV power device 1103a may comprise transistors Q3, Q4 and Q5. Transistors Q3-Q5 may be MOSFETs, JFETs, IGBTs, BJTs or other appropriate transistors. For the illustrative embodiment of Fig. 11A, transistors Q3-Q5 will be assumed to be MOSFETs. Transistor Q3 may be connected between input terminals T2 and T3. Transistor Q4 may be connected between input terminals T2 and T4. Transistor Q1 may be connected between input terminals T1 and T3. Transistors Q3-Q5 may be controlled (e.g. have gate signals provided) by one or more controllers such as controller 905 of PV power device 903. The elements comprising PV power device 1103a may be jointly enclosed by enclosure 1108.

A first PV generator (not explicitly depicted) may be coupled between terminals T1 and T2, and a second PV generator (not explicitly depicted) may be coupled between terminals T3 and T4. Under normal operating conditions, transistor Q3 may be ON, and transistors Q4 and Q5 may be OFF. Under these conditions, the two photovoltaic generators may be serially connected, with the combined serial voltage of the two PV generators provided between terminals T1 and T4. When a potentially unsafe condition is detected, the controller controlling transistor Q3 may turn Q3 to the OFF state, reducing the voltage drop between terminals T1 and T4.

Even when transistor Q3 is OFF, power may still be provided at the input to PV power device 903. For example, in some embodiments, controller(s) controlling transistors Q4 and Q5 may switch Q4 and Q5 to the ON state when Q3 is OFF, resulting in terminal T1 being short-circuited to terminal T3, and terminal T2 being short-circuited to terminal T4. Under these conditions, the first and second photovoltaic generator may be coupled in parallel between terminal T1 and T4, allowing PV power device 903 to draw power from the PV generators (e.g. for powering devices such as controller 905, communication device 911, auxiliary power circuit 908 and other devices depicted in Fig. 9). In some embodiments, Q4 or Q5 might not be included in PV power device 1103a. For example, Q4 might not be included, in which case by turning Q5 to the ON position when Q3 is OFF, power is provided to PV power device 903 by a single PV generator (coupled between T3 and T4). Similarly, Q5 might not be included, in which case by turning Q4 to the ON position when Q3 is OFF, power is provided to PV power device 903 by a single PV generator (coupled between T1 and T2).

Reference is now made to Fig. 11B, which shows a photovoltaic power device according to illustrative embodiments. PV power device 1103b may be used as PV power device 1003 of Fig. 10. PV power device 1103b may comprise a PV power device similar to or the same as PV power device 803 of Fig. 8 or PV power device 903 of Fig. 9. For convenience, in the illustrative embodiments of Fig. 11A and Fig. 11B, PV power device 1103a will be assumed to comprise PV power device 903 of Fig. 9.

Transistor Q6 may be similar to or the same as transistor Q3 of Fig. 11A. PV power device 1103b may further comprise diodes D3 and D4. The anode of diode D3 may be coupled to terminal T3 and the cathode of diode D3 may be coupled to the positive input of PV power device 903 at node N1. The anode of diode D4 may be coupled to terminal T1 and the cathode of diode D3 may be coupled to the positive input of PV power device 903 at node N1. The elements comprising PV power device 1103b may be jointly enclosed by enclosure 1108.

Still referring to Fig. 11B, a first PV generator (not explicitly depicted) may be coupled between terminals T1 and T2, and a second PV generator (not explicitly depicted) may be coupled between terminals T3 and T4. Under normal operating conditions, transistor Q3 may be ON, connecting terminals T2 and T3. The voltage at terminal T1 may be higher than the voltage at terminal T2 (e.g. if the positive output of a PV generator is coupled to terminal T1 and the negative output of the PV generator is coupled to terminal T2), so diode D4 may be forward-biased and diode D3 may be reverse-biased. The voltage at node N1 may be about the voltage at terminal T1 (assuming an insignificant voltage drop across diode D4), resulting in a voltage input to PV power device 903 about equal to the voltage between terminals T1 and T4.

When a potentially unsafe condition is detected, the controller controlling transistor Q6 may turn Q6 to the OFF state, disconnecting the coupling of terminals T2 and T3. The voltage at node N1 may be the voltage at terminal T1 or the voltage at terminal T3, the greater of the two. While the voltage at node N1 might not be predetermined, in either possible scenario, a PV generator may be coupled to the inputs of PV power device 903, providing power to PV power device 903 (e.g. for powering devices such as controller 905, communication device 911, auxiliary power circuit 908 and other devices depicted in Fig. 9).

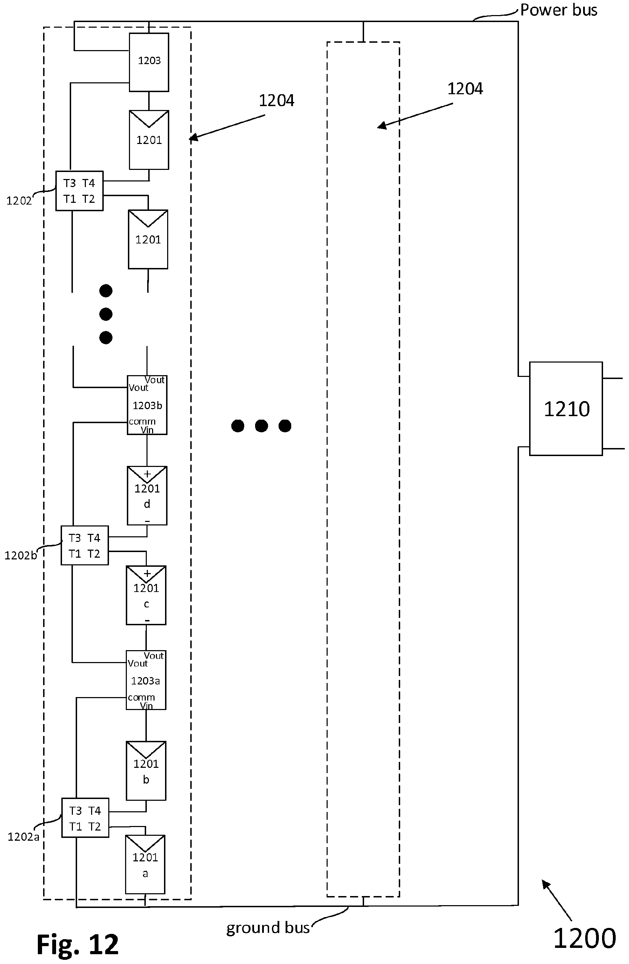

Reference is now made to Fig. 12, which shows a photovoltaic (PV) system according to illustrative embodiments. PV system 1200 may comprise a plurality of PV strings 1204 coupled in parallel between a ground bus and a power bus. Each of PV strings 1204 may comprise a plurality of photovoltaic generators 1201, a pliurality of safety switches 1202 and a plurality of PV power devices 1203. PV generators 1001 may be similar to or the same as PV generators 801 of Fig. 8. In some embodiments, the power and ground buses may be input to system power device 1210, which may be similar to or the same as system power device 810 of Fig. 8.

Each PV power device 1203 may be designed to be coupled to more than one PV power generator 1201. For example, in PV system 1200, each PV power device 1203 (except for the PV power devices coupled to the power bus) is coupled to two PV power generators and to two safety switches 1202, with each safety switch 1202 (except for the safety switch 1202 which is coupled to the ground bus) coupled to two PV generators 1201 and two PV power devices 1203.

Under normal operating conditions, each PV power device 1203 may receive power from two PV generators 1201, and may forward the power along PV string 1204 towards the power bus. Under normal operating conditions, each safety switch 1202 may provide a connection between two PV generators 1201 and may provide a connection between two PV power devices 1203 for forwarding power along PV string 1204. For example, under normal operating conditions, safety switch 1202a provides a connection between PV generators 1201a and 1201b. PV power device 1203a may receive power generated by PV generators 1201a and 1201b, with safety switches 1202b disposed between PV power devices 1203a and 1203b, providing PV power device 1203a with a connection for forwarding power to PV power device 1203b. Similarly, safety switch 1202b provides a connection between PV generators 1201c and 1201d, with PV power device 1203b receiving power from PV generators 1201c and 1201d.

In case of an unsafe condition, safety switch 1202a may be operated to disconnect PV generator 1201a from PV generator 1201b, and to disconnect PV power device 1203a from the ground bus. Similarly, safety switch 1202b may be operated to disconnect PV generator 1201c from PV generator 1201d, and to disconnect PV power device 1203a PV power device 1203b. Operating safety switches 1202 in this manner may reduce the voltage in various locations in PV system 1200 to safe voltage levels.

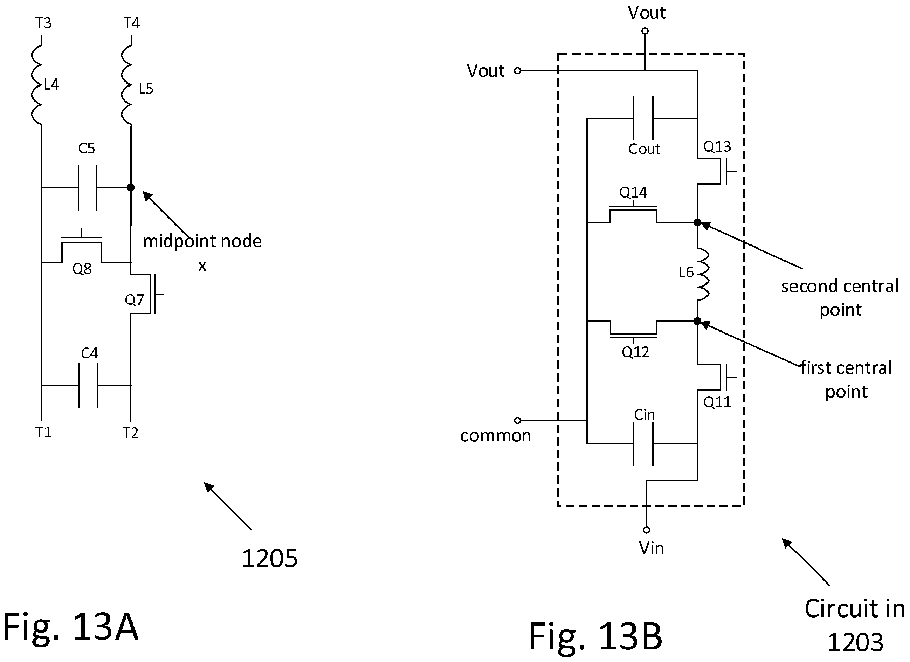

Reference is now made to Fig. 13A, which shows safety switch 1205 according to an illustrative embodiment. Safety switch 1205 may comprise terminals T1-T4, transistors (e.g. MOSFETs) Q7 and Q8, capacitors C4 and C5, and inductors L4 and L5. Inductor L4 may be provided between terminal T3 and terminal T1 to reduce ripples and/or spikes in a current flowing from terminal T1 to terminal T3, and inductor L5 may be provided between terminal T4 and midpoint node X to reduce ripples and/or spikes in a current flowing from transistor Q7 to terminal T4. In some embodiments, inductors L4 and L5 might not be provided. In some embodiments, transistors Q7 and Q8 may be replaced by alternative switching elements, such as IGBTs, BJTs, JFETs or other switching elements. Capacitor C4 may be coupled between terminals T1 and T2. Transistor Q7 may be coupled between terminal T2 and midpoint node X, and capacitor C5 may be coupled between terminal T1 and midpoint node X. Transistor Q8 may be coupled in parallel to capacitor C5, between terminal T1 and midpoint node X. In some embodiments, capacitor C5 and/or capacitor C4 might not be provided.

During normal system operation, transistor Q7 may be held in the ON state, and transistor Q8 may be in the OFF state. Capacitor C5 may then be in parallel with capacitor C4, and a first PV generator may be coupled between terminals T1 and T2, applying a voltage to capacitors C4 and C5 and providing electrical power at terminals T1 and T2. Terminal T4 may be coupled to an output terminal of a second PV generator, and terminal T3 may be coupled to an input terminal of a PV power device 1203. The power input to safety switch 1205 at terminals T1 and T2 may be output at terminals T3 and T4 to the second PV generators and the PV power device 1203.

Transistors Q7 and Q8 may be controlled by a controller (not explicitly depicted) similar to or the same as controller 710 of Fig. 7A. In some embodiments, the controller may be powered by capacitor C4 (e.g. a controller input power terminal may be coupled to terminal T2 or terminal T1 for receiving power from capacitor C4). Safety switch 1205 may further comprise a communication device (e.g. similar to or the same as communication device 305 of Fig. 3) for receiving operational commands from a system control device.

When an unsafe condition is detected, the controller may switch transistor Q7 to the OFF state and transistor Q8 to the ON state. Capacitor C5 may be short-circuited by transistor Q8, while capacitor C4 may maintain the voltage imposed between terminals T1 and T2.

Reference is now made to Fig. 13B, which shows some of the internal circuitry of a photovoltaic power device according to one illustrative embodiment. In some embodiments, PV power device 1203 may comprise a variation of a Buck + Boost DC/DC converter. The power device may include a circuit having two input terminals, denoted **Vin** and **common,** and two output terminals which output the same voltage **Vout.** The output voltage is in relation to the common terminal. The circuit may include an input capacitor **Cin** coupled between the common terminal and the **Vin** terminal, an output capacitor coupled between the common terminal and the **Vout** terminals. The circuit may include two central points used for reference. The circuit may include a plurality of switches (e.g. MOSFET transistors) **Q11, Q12, Q13** and **Q14** with **Q11** connected between **Vin** and the first central point, and **Q12** connected between the common terminal and the first central point. **Q13** may be connected between the **Vout** terminal and the second central point, and **Q14** may be connected between the common terminal and the second central point. The circuit may further include inductor **L6** coupled between the two central points.

The operation of the Buck + Boost DC/DC converter in PV power device 1203 may be variously configured. If an output voltage lower than he input voltage is desired, **Q13** may be statically ON, **Q14** may be statically OFF, and with **Q11** and **Q12** being Pulse-Width-Modulation(PWM)-switched in a complementary manner to one another, the circuit is temporarily equivalent to a Buck converter and the input voltage is bucked. If an output voltage higher than he input voltage is desired, **Q11** may be statically ON, **Q12** may be statically OFF, and with **Q13** and **Q14** being PWM-switched in a complementary manner to one another, the input voltage is boosted. Staggering the switching of switches **Q11** and **Q12,** the circuit may convert the input voltage **Vin** to output voltage **Vout.** If current is input to the circuit by the Vin and common terminals, and the voltage drop across capacitors **Cin** and **Cout** are about constant voltages **Vin** and **Vout** respectively, the currents input to the circuit are combined at inductor **L6** to form an inductor current which is equal to the sum of the current input at the **Vin** and **common** terminals. The inductor current may contain a ripple due to the charging and discharging of capacitors **Cin** and **Cout,** but if the voltage drop across capacitors **Cin** and **Cout** are about constant, the voltage ripples over the capacitors are small, and similarly the inductor current ripple may be small. The inductor current may be output by the pair of output terminals **Vout.** In some embodiments, a single output terminal may be included, and system designers may split the output terminal externally (i.e. outside of the PV power device circuit), if desired.

In illustrative embodiments, PV power device 1203 may be similar to or the same as PV power device 903 of Fig. 9, with power converter 900 of Fig. 9 comprising the Buck + Boost converter of Fig. 13B. In some embodiments, boosting the voltage input to a PV power device 1203 might not be necessary, in which case PV power device 1203 may comprise a Buck converter similar to the Buck + Boost converter of Fig. 13B, with switch Q14 removed (i.e. replaced by an open-circuit) and switch Q13 replaced with a wire (i.e. connecting the **Vout** terminal to the second central point).

Referring back to Fig. 12, safety switch 1202b may be coupled to photovoltaic generators 1201c and 1201d, and to PV power devices 1203a and 1203b. Terminal T2 may be connected to the positive output of PV generator 1201c, and terminal T4 may be connected to the negative output of PV generator 1201d. Terminal T1 may be coupled to a first Vout terminal of PV power device 1203a, and terminal T3 may be coupled to the common terminal of PV power device 1203b. The positive output terminal of PV generator 1201d may be coupled to the **Vin** terminal of PV power device 1203b, and the negative output terminal of PV generator 1201c may be coupled to a second **Vout** terminal of PV power device 1203a. Under normal operating conditions, PV generators 1201c and 1201d are serially coupled, the combined voltage of PV generators 1201c and 1201d input between the common and **Vin** terminals of PV power device 1203b. If an unsafe condition is detected, safety switch 1202b may disconnect the connection between terminals T2 and T4 (e.g. by setting transistor Q7 of Fig. 13A to OFF) and couple terminals T3 and T4 (e.g. by setting transistor Q8 of Fig. 13A to ON). As a result, PV generator 1201d may be coupled between the common and Vin terminals of PV power device 1203b, and PV generator 1201c may be coupled between terminals T1 and T2 of safety switch 1202b.

The system topology illustrated in Fig. 12 may provide certain advantages. For example, during normal system operation, two PV generators 1201 provide a combined voltage and power to a PV power device 1203, requiring a reduced number of PV power devices for processing power generated by the PV generators. Furthermore, continuous operational power (i.e. power used for powering device components such as controllers and transistors) is provided to all PV power devices 1203 and safety switches 1202 both during normal operations and during a potentially unsafe condition.

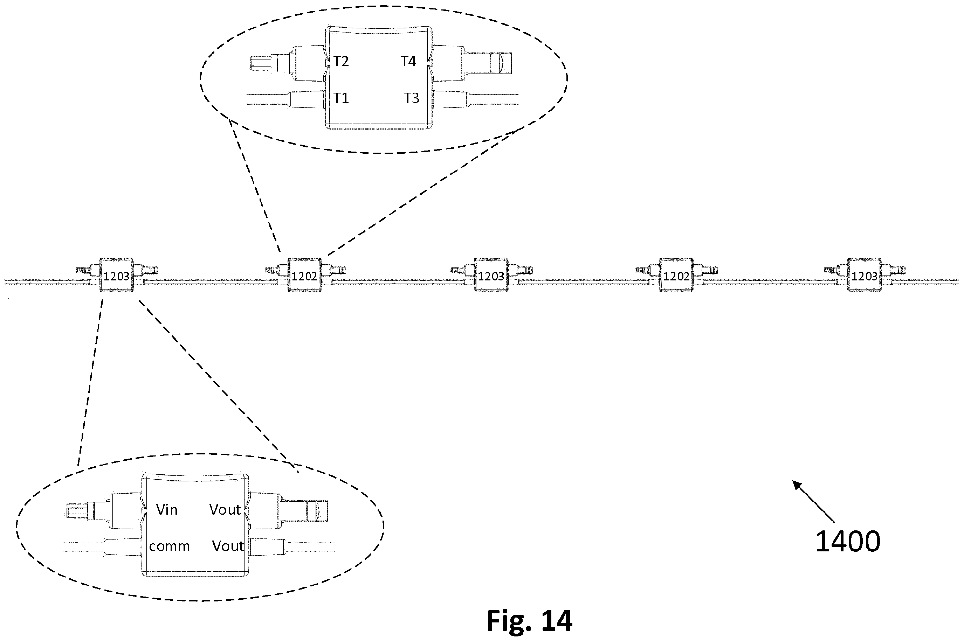

Reference is now made to Fig. 14, which shows part of a chain of photovoltaic devices according to an illustrative embodiment. Chain 1400 may comprise a plurality of PV power devices 1203 and a plurality of safety switches 1202. Each safety switch 1202 may be connected, using conductors, between two PV power devices 1203. Terminal T1 of safety switch 1202 may be connected to a **Vout** terminal of a first PV power device, and terminal T3 of safety switch 1202 may be connected to a common terminal of a second PV power device. Terminals T2 and T4 may be accessible via external connectors similar to or the same as connectors 406 and 407 of Fig. 4A. Similarly, a **Vout** terminal and a **Vin** terminal of each PV power device 1203 may be accessible via external connectors similar to or the same as connectors 406 and 407 of Fig. 4A. Conductors connecting a PV power device terminal (e.g. the common terminal) to a safety switch terminal (e.g. terminal T3) may be sized to facilitate connecting chain 1400 to a plurality of PV generators, as depicted in Fig. 12. For example, in locales where PV generators are commonly 1-2 meters wide, each conductor disposed between a safety switch 1202 and a PV power device 1203 may be about 1-2 meters long. Chain 1400 may be assembled and sold as a single unit, saving cost and time when constructing a PV installation similar to or the same as PV system 1200 of Fig. 12.

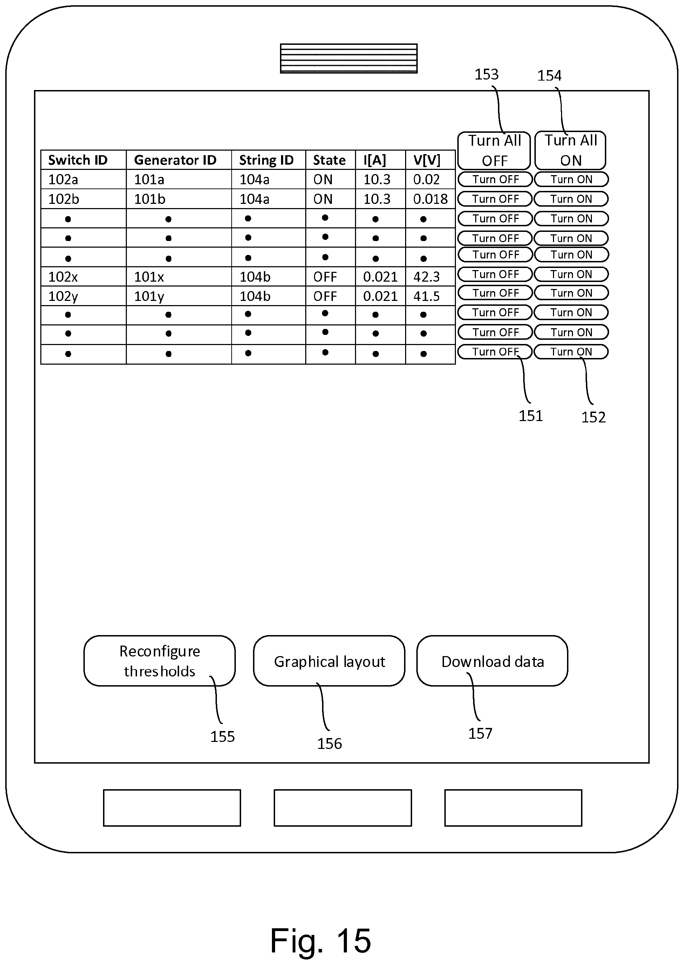

Referring to Fig. 15, an illustrative application running on a smart phone, tablet, computer, workstation, mobile device (such as a cellular device) and/or a similar computing device is shown. The application may provide a list of safety switches disposed in an electrical power system (e.g. PV system 100 of Fig. 1). The application may indicate a serial number or other identifying information of each safety switch, as well as identifying information of coupled PV generators and/or identifying information of a PV string each safety switch is coupled to. In some embodiments, the application may indicate the state of each safety switch and/or electrical parameters of one or more safety switches, for example, the voltage across or current through one or more safety switches. In some embodiments, the application may provide touch-screen buttons or similar input controllers for controlling the state of one or more switches. For example, activating a button 151 may move an associated safety switch to the OFF state, and activating a button 152 may move an associated safety switch to the ON state. Activating button 153 may move all safety switches to the OFF state, and activating button 154 may move all safety switches to the ON state. In some embodiments, activating buttons 151-154 may be restricted based on a user access level. For example, the application may enable buttons 151-154 only when running in "Installer/Administrator" mode, to restrict the actions of unsophisticated users.

Still referring to Fig. 15, activating button 155 may enable a user to reconfigure a threshold. For example, an electrical voltage, current or power threshold which may be indicative of an arcing condition and trigger a system response (e.g. moving one or more safety switches to the OFF state) may be reconfigured by a user using the application of Fig. 15. Activating button 156 may display a graphical layout of an electrical system represented by the application, including physical location details of one or more safety switches. Activating button 157 may download current or past operational system data such as the state of safety switches, and/or electrical parameter measurement measured by safety switches. Buttons 155-157 may similarly be restricted depending on the level of user authorization.

The application of Fig. 15 may communicate directly with safety switches via wireless communications (e.g. cellular communication, or over the internet). In some embodiments, the application may communicate with a system power device (e.g. system power device 110 of Fig. 1), with the system power device configured to relay communication between the application and the safety switches via wireless communication or wired communication (e.g. power line communication).

In illustrative embodiments disclosed herein, photovoltaic generators are used as examples of power sources which may make use of the novel features disclosed. Each PV generator may comprise one or more solar cells, one or more solar cell strings, one or more solar cell substrings, one or more solar panels, one or more solar shingles, or combinations thereof. According to aspects of the disclosure, the power sources may include batteries, flywheels, wind or hydroelectric turbines, fuel cells or other energy sources in addition to or instead of photovoltaic generators. Systems, apparatuses and methods disclosed herein which use PV generators may be equally applicable to alternative systems using additional power sources, and these alternative systems are included in embodiments disclosed herein.

It is noted that various connections are set forth between elements herein. These connections are described in general and, unless specified otherwise, may be direct or indirect; this specification is not intended to be limiting in this respect. Further, elements and/or features described with regard to one embodiment may be combined with elements and/or features from other embodiments in appropriate combinations or subcombinations. For example, PV power device circuitry of one embodiments may be combined with and/or exchanged for power device circuitry of a different embodiment. For example, transistor Q9 of PV power device 903 may be disposed between electrical connections 512 and 513 of junction box 511 and operated to short-circuit the input to PV generator 101 of Fig. 5A.

## Claims

1. An apparatus comprising:
a first electrical connector (306, 408) designed to be connectable to a first power source (101, 801, 1001);
a second electrical connector (307, 403) designed to be connectable to a second power source (101, 801, 1001);
a first electrical conductor (308, 409, 708) coupled to the first electrical connector ;
a second electrical conductor (309, 404, 709) coupled to the second electrical connector;
a switching element (Q1) coupled in series, via the first electrical conductor and the second electrical conductor, between the first electrical connector and the second electrical connector, wherein the switching element comprises a transistor comprising a source terminal (Vs) coupled to the first electrical conductor, a drain terminal (Vd) coupled to the second electrical conductor and a gate terminal (Vg);
a controller (303, 503, 710) coupled to the gate terminal serving as a control terminal of the switching element, the controller configured to be responsive to an indication of a potentially unsafe condition and configured to:
control the switching element to an ON state to connect the first electrical conductor to the second electrical conductor, and
in response to an indication of a potentially unsafe condition, control the switching element to an OFF state to disconnect the first electrical conductor from the second electrical conductor; and
an auxiliary power circuit (304, 504, 704, 702a, 704a) comprising a DC/DC converter (720), wherein a first input to the converter is coupled to the source terminal and a second input to the converter is coupled to the drain terminal, wherein the converter is configured to convert the drain-to-source voltage at its inputs to a larger voltage at its output for powering the controller.

2. The apparatus of claim 1, wherein the first power source (101, 801, 1001) comprises a first photovoltaic generator, and wherein the second power source (101, 801, 1001) comprises a second photovoltaic generator.

3. The apparatus of any preceding claim, further comprising the first power source (101, 801, 1001) and the second power source (101, 801, 1001), wherein the first power source (101, 801, 1001) and the second power source (101, 801, 1001) are connected in series when the switching element is in the ON state, and wherein the first power source and the second power source are disconnected when the switching element is in the OFF state.

4. The apparatus of any preceding claim, further comprising a communication device (305, 505) coupled to the controller (303, 503), wherein the communication device is configured to receive an indication of the potentially unsafe condition, and to provide the indication of the potentially unsafe condition to a system control device.

5. The apparatus of claim 4, wherein the communication device (305, 505) comprises at least one of a power line communication device or a wireless communication device.

6. The apparatus of claim 4, further comprising a sensor (310, 510) coupled to the controller (303, 503), wherein the sensor is configured to measure one or more electrical parameters and to provide one or more measurements to the controller, and wherein the one or more measurements include the indication of the potentially unsafe condition.

7. The apparatus of claim 6, wherein the sensor (310, 510) is a current sensor, wherein indication of the potentially unsafe condition includes at least one of: a high current measurement, a measurement indicating a change in current flow, or a measurement indicating a mismatch with another electrical parameter.

8. The apparatus of any preceding claim, further comprising a resistor coupled in parallel to the switching element (Q1).

9. The apparatus of any preceding claim, wherein the controller (303) is an analog circuit.

10. A method comprising:
receiving, by a controller (303, 503, 710), operational power provided by an auxiliary power circuit (304, 504, 704, 702a, 704a);
detecting, by the controller, a potentially unsafe condition at a power generation installation comprising a plurality of power sources (101, 801, 1001) and a safety switch (102, 302, 402, 502, 802), wherein the safety switch is coupled in series, via a first electrical conductor (308, 409, 708) and a second electrical conductor (309, 404, 709), between a first electrical connector (306, 408) and a second electrical connector (307, 403), wherein the safety switch comprises a switching element (Q1), wherein the switching element comprises a transistor comprising a source terminal (Vs) coupled to the first electrical conductor, a drain terminal (Vd) coupled to the second electrical conductor and a gate terminal (Vg), wherein the auxiliary power circuit comprises a DC/DC converter (720), wherein a first input to the converter is coupled to the source terminal and a second input to the converter is coupled to the drain terminal, and wherein the first electrical connector is connected to a first power source of the plurality of power sources and the second electrical connector is connected to a second power source of the plurality of power sources;
in response to the detecting the potentially unsafe condition, controlling, by the controller, the safety switch via the gate terminal serving as a control terminal of the safety switch to disconnect the first electrical connector from the second electrical connector;
determining, by the controller, that the potentially unsafe condition has been resolved;
in response to the determining, controlling, by the controller, the safety switch via the gate terminal to connect the first electrical connector to the second electrical connector; and
converting, by the converter of the auxiliary power circuit (304, 504, 704, 704a), the drain-to-source voltage at its inputs to a larger voltage at its output for powering the controller,
wherein the controlling the safety switch to disconnect the first electrical connector from the second electrical connector comprises setting the switching element (Q1) to an OFF state, and
wherein the controlling the safety switch to connect to the first electrical connector to the second electrical connector comprises setting the switching element to an ON state.

11. The method of claim 10, wherein the detecting of the potentially unsafe condition comprises receiving an electrical parameter measurement and determining that the electrical parameter measurement is indicative of the potentially unsafe condition.

12. The method of claim 11, wherein the receiving the electrical parameter measurement comprises receiving an electrical current measurement, and wherein the electrical parameter measurement indicative of the potentially unsafe condition comprises at least one of: a high current measurement, the electrical current measurement indicating a change in current flow, or the electrical current measurement indicating a mismatch with another electrical parameter.

13. The method of any of claims 10 to 12, wherein the determining that the potentially unsafe condition has been resolved comprises receiving, via a communication device (305, 505), a command from a system control device .

14. The method of any of claims 10 to 12, further comprising receiving, by the controller (303, 503), a keep alive signal from a system control device, wherein the detecting, by the controller, of the potentially unsafe condition, comprises not receiving the keep alive signal.

15. The method of any of claims 10 to 14, wherein the controller (303) is an analog circuit.

## Patentansprüche

1. Vorrichtung, umfassend:
einen ersten elektrischen Steckverbinder (306, 308), der dazu ausgelegt ist, mit einer ersten Leistungsquelle (101, 801, 1001) verbindbar zu sein;
einen zweiten elektrischen Steckverbinder (307, 403), der dazu ausgelegt ist, mit einer zweiten Leistungsquelle (101, 801, 1001) verbindbar zu sein;
einen ersten elektrischen Leiter (308, 409, 708), der mit dem ersten elektrischen Steckverbinder gekoppelt ist;
einen zweiten elektrischen Leiter (309, 404, 709), der mit dem zweiten elektrischen Steckverbinder gekoppelt ist;
ein Schaltelement (Q1), das über den ersten elektrischen Leiter und den zweiten elektrischen Leiter zwischen dem ersten elektrischen Steckverbinder und dem zweiten elektrischen Steckverbinder in Reihe geschaltet ist, wobei das Schaltelement einen Transistor umfasst, der einen Source-Anschluss (Vs), der mit dem ersten elektrischen Leiter gekoppelt ist, einen Drain-Anschluss (Vd), der mit dem zweiten elektrischen Leiter gekoppelt ist, und einen Gate-Anschluss (Vg) umfasst;
einen Controller (303, 503, 710), der mit dem Gate-Anschluss gekoppelt ist, der als ein Steueranschluss des Schaltelements dient, wobei der Controller dazu konfiguriert ist, auf eine Angabe eines potentiell unsicheren Zustands zu reagieren, und dazu konfiguriert ist:
das Schaltelement in einen EIN-Zustand zu steuern, um den ersten elektrischen Leiter mit dem zweiten elektrischen Leiter zu verbinden; und
in Reaktion auf eine Angabe eines potentiell unsicheren Zustands, das Schaltelement in einen AUS-Zustand zu versetzen, um den ersten elektrischen Leiter von dem zweiten elektrischen Leiter zu trennen; und
eine Hilfsleistungsschaltung (304, 504, 704, 702a, 704a), die einen Gleichstromwandler (720) umfasst, wobei ein erster Eingang des Wandlers mit dem Source-Anschluss gekoppelt ist und ein zweiter Eingang des Wandlers mit dem Drain-Anschluss gekoppelt ist, wobei der Wandler dazu konfiguriert ist, die zwischen Drain und Source anliegende Spannung an seinen Eingängen in eine höhere Spannung an seinem Ausgang umzuwandeln, um den Controller zu bestromen.

2. Vorrichtung gemäß Anspruch 1, wobei die erste Leistungsquelle (101, 801, 1001) einen ersten photovoltaischen Generator umfasst und wobei die zweite Leistungsquelle (101, 801, 1001) einen zweiten photovoltaischen Generator umfasst.

3. Vorrichtung gemäß einem der vorhergehenden Ansprüche, ferner umfassend die erste Leistungsquelle (101, 801, 1001) und die zweite Leistungsquelle (101, 801, 1001), wobei die erste Leistungsquelle (101, 801, 1001) und die zweite Leistungsquelle (101, 801, 1001) in Reihe geschaltet sind, wenn das Schaltelement in dem EIN-Zustand ist, und wobei die erste Leistungsquelle und die zweite Leistungsquelle voneinander getrennt sind, wenn das Schaltelement in dem AUS-Zustand ist.

4. Vorrichtung gemäß einem der vorhergehenden Ansprüche, ferner umfassend eine Kommunikationseinrichtung (305, 505), die mit dem Controller (303, 503) gekoppelt ist, wobei die Kommunikationseinrichtung dazu konfiguriert ist, eine Angabe über den potentiell unsicheren Zustand zu empfangen und die Angabe über den potentiell unsicheren Zustand an eine Systemsteuerungseinrichtung zu liefern.

5. Vorrichtung gemäß Anspruch 4, wobei die Kommunikationseinrichtung (305, 505) mindestens eine aus einer Powerline-Kommunikationseinrichtung oder einer drahtlosen Kommunikationseinrichtung umfasst.

6. Vorrichtung gemäß Anspruch 4, ferner umfassend einen Sensor (310, 510), der mit dem Controller (303, 503) gekoppelt ist, wobei der Sensor dazu konfiguriert ist, einen oder mehrere elektrische Parameter zu messen und eine oder mehrere Messungen an den Controller zu liefern, und wobei die eine oder die mehreren Messungen die Angabe über den potentiell unsicheren Zustand enthalten.

7. Vorrichtung gemäß Anspruch 6, wobei der Sensor (310, 510) ein Stromsensor ist, wobei die Angabe über den potentiell unsicheren Zustand mindestens eine aus den Folgenden enthält: eine hohe Strommessung, eine Messung, die eine Änderung im Stromfluss angibt, oder eine Messung, die eine fehlende Übereinstimmung mit einem anderen elektrischen Parameter anzeigt.

8. Vorrichtung gemäß einem der vorhergehenden Ansprüche, ferner umfassend einen Widerstand, der mit dem Schaltelement (Q1) parallel geschaltet ist.

9. Vorrichtung gemäß einem der vorhergehenden Ansprüche, wobei der Controller (303) ein analoger Schaltkreis ist.

10. Verfahren, umfassend:
Empfangen, durch einen Controller (303, 503, 710), von Betriebsleistung, die von einer Hilfsleistungsschaltung (304, 504, 704, 702a, 704a) geliefert wird;
Erfassen, durch den Controller, eines potentiell unsicheren Zustands an einer Stromerzeugungsanlage, die eine Mehrzahl von Leistungsquellen (101, 801, 1001) und einen Sicherheitsschalter (102, 302, 402, 502, 802) umfasst, wobei der Sicherheitsschalter über einen ersten elektrischen Leiter (308, 409, 708) und einen zweiten elektrischen Leiter (309, 404, 709) zwischen einem ersten elektrischen Steckverbinder (306, 408) und einem zweiten elektrischen Steckverbinder (307, 403) in Reihe geschaltet ist, wobei der Sicherheitsschalter ein Schaltelement (Q1) umfasst, wobei das Schaltelement einen Transistor umfasst, der einen Source-Anschluss (Vs), der mit dem ersten elektrischen Leiter gekoppelt ist, einen Drain-Anschluss (Vd), der mit dem zweiten elektrischen Leiter gekoppelt ist, und einen Gate-Anschluss (Vg) umfasst, wobei die Hilfsleistungsschaltung einen Gleichstromwandler (720) umfasst, wobei ein erster Eingang des Wandlers mit dem Source-Anschluss gekoppelt ist und ein zweiter Eingang des Wandlers mit dem Drain-Anschluss gekoppelt ist, und wobei der erste elektrische Steckverbinder mit einer ersten Leistungsquelle aus der Mehrzahl von Leistungsquellen verbunden ist und der zweite elektrische Steckverbinder mit einer zweiten Leistungsquelle aus der Mehrzahl von Leistungsquellen verbunden ist;
in Reaktion auf das Erfassen des potentiell unsicheren Zustands, Steuern, durch den Controller, des Sicherheitsschalters über den Gate-Anschluss, der als ein Steueranschluss des Sicherheitsschalters dient, um den ersten Steckverbinder von dem zweiten elektrischen Steckverbinder zu trennen;
Bestimmen, durch den Controller, dass der potentiell unsichere Zustand aufgehoben wurde;
in Reaktion auf das Bestimmen, Steuern, durch den Controller, des Sicherheitsschalters über den Gate-Anschluss zum Verbinden des ersten elektrischen Steckverbinders mit dem zweiten elektrischen Steckverbinder; und
Umwandeln, durch den Wandler der Hilfsleistungsschaltung (304, 504, 704, 704a) der zwischen Drain und Source anliegenden Spannung an seinen Eingängen in eine höhere Spannung an seinem Ausgang, um den Controller zu bestromen,
wobei das Steuern des Sicherheitsschalters zum Trennen des ersten elektrischen Steckverbinders von dem zweiten elektrischen Steckverbinder ein Einstellen des Schaltelements (Q1) in einen AUS-Zustand umfasst, und
wobei das Steuern des Sicherheitsschalters zum Verbinden des ersten elektrischen Steckverbinders mit dem zweiten elektrischen Steckverbinder ein Einstellen des Schaltelements (Q1) in einen EIN-Zustand umfasst.

11. Verfahren gemäß Anspruch 10, wobei das Erfassen des potentiell unsicheren Zustands ein Empfangen einer elektrischen Parametermessung und ein Bestimmen umfasst, dass die elektrische Parametermessung den potentiell unsicheren Zustand anzeigt.

12. Verfahren gemäß Anspruch 11, wobei das Empfangen der elektrischen Parametermessung ein Empfangen einer elektrischen Strommessung umfasst, und wobei die elektrische Parametermessung, die den potentiell unsicheren Zustand anzeigt, mindestens eine aus den Folgenden umfasst: eine hohe Strommessung, die elektrische Strommessung, die eine Änderung im Stromfluss angibt, oder die elektrische Strommessung, die eine fehlende Übereinstimmung mit einem anderen elektrischen Parameter anzeigt.

13. Verfahren gemäß einem der Ansprüche 10 bis 12, wobei das Bestimmen, dass der potentiell unsichere Zustand aufgehoben wurde, ein Empfangen, über eine Kommunikationseinrichtung (305, 505), eines Befehls von einer Systemsteuerungseinrichtung umfasst.

14. Verfahren gemäß einem der Ansprüche 10 bis 12, ferner umfassend Empfangen, durch den Controller (303, 503), eines Keep-Alive-Signals von einer Systemsteuerungseinrichtung, wobei das Erfassen, durch den Controller, des potentiell unsicheren Zustands, umfasst, dass das Keep-Alive-Signal nicht empfangen wird.

15. Verfahren gemäß einem der Ansprüche 10 bis 14, wobei der Controller (303) ein analoger Schaltkreis ist.

## Revendications

1. Un appareil comprenant :
un premier connecteur électrique (306, 408) conçu pour être connectable à une première source d'énergie (101, 801, 1001);
un deuxième connecteur électrique (307, 403) conçu pour être connectable à une deuxième source d'énergie (101, 801, 1001);
un premier conducteur électrique (308, 409, 708) couplé au premier connecteur électrique,
un deuxième conducteur électrique (309, 404, 709) couplé au deuxième connecteur électrique;
un élément de commutation (QI) couplé en série, via le premier conducteur électrique et le deuxième conducteur électrique, entre le premier connecteur électrique et le deuxième connecteur électrique, dans lequel l'élément de commutation comprend un transistor comprenant une borne de source (Vs) couplée au premier conducteur électrique, une borne de drain (Vd) couplée au deuxième conducteur électrique et une borne de grille (Vg);
un organe de contrôle (303, 503, 710) couplé à la borne de grille servant de borne de contrôle de l'élément de commutation, l'organe de contrôle étant configuré pour être réactif à une indication d'un état potentiellement dangereux et configuré pour:
la commande de l'élément de commutation à un état ON afin de connecter le premier conducteur électrique au deuxième conducteur électrique et,
le contrôle, en réponse à une indication d'une condition potentiellement dangereuse, de l'élément de commutation à un état OFF pour déconnecter le premier conducteur électrique du deuxième conducteur électrique; et
un circuit d'énergie auxiliaire (304, 504, 704, 702a, 704a) comprenant un convertisseur CC/CC (720), dans lequel une première entrée du convertisseur est couplée à la borne de source et une deuxième entrée du convertisseur est couplée à la borne de drain, dans lequel le convertisseur est configuré pour convertir la tension drain-source de ses entrées en une tension plus importante à la sortie aux fins d'alimenter l'organe de contrôle.

2. L'appareil selon la revendication 1, dans lequel la première source d'énergie (101, 801, 1001) comprend un premier générateur photovoltaïque, et dans lequel la deuxième source d'énergie (101, 801, 1001) comprend un deuxième générateur photovoltaïque.

3. L'appareil selon une quelconque des revendications précédentes, comprenant en outre la première source d'énergie (101, 801, 1001) et la deuxième source d'énergie (101, 801, 1001), dans lequel la première source d'énergie (101, 801, 1001) et la deuxième source d'énergie (101, 801, 1001) sont connectées en série lorsque l'élément de commutation est à l'état ON et dans lequel la première source d'énergie et la deuxième source d'énergie sont déconnectées lorsque l'élément de commutation est à l'état OFF.

4. L'appareil selon une quelconque des revendications précédentes, comprenant en outre un dispositif de communication (305, 505) couplé à l'organe de contrôle (303, 503), dans lequel le dispositif de communication est configuré pour recevoir une indication de l'état potentiellement dangereux et pour fournir l'indication de l'état potentiellement dangereux au dispositif de contrôle du système.

5. L'appareil selon la revendication 4, dans lequel le dispositif de communication (305, 505) comprend au moins un dispositif de communication par courant porteur ou un dispositif de communication sans fil.

6. L'appareil selon la revendication 4, comprenant en outre un détecteur (310, 510) couplé à l'organe de contrôle (303, 503), dans lequel le détecteur est configuré pour mesurer un ou plusieurs paramètres électriques et pour fournir une ou plusieurs mesures à l'organe de contrôle, et dans lequel les une ou plusieurs mesures incluent l'indication de l'état potentiellement dangereux.

7. L'appareil selon la revendication 6, dans lequel le détecteur (3 10, 510) est un détecteur de courant, dans lequel l'indication de l'état potentiellement dangereux comprend au moins l'une des mesures suivantes : une mesure de courant élevé, une mesure indiquant un changement dans le flux de courant ou une mesure indiquant une discordance avec un autre paramètre électrique.

8. L'appareil selon une quelconque des revendications précédentes, comprenant en outre une résistance couplée en parallèle à l'élément de commutation (QI).

9. L'appareil selon une quelconque des revendications précédentes, dans lequel l'organe de contrôle (303) est un circuit analogique.

10. Un procédé comprenant :
la réception, par un organe de contrôle (303, 503, 710), d'une puissance opérationnelle fournie par un circuit d'énergie auxiliaire (304, 504, 704, 702a, 704a);
la détection, par l'organe de contrôle, d'une condition potentiellement dangereuse dans une installation de production d'énergie comprenant une pluralité de sources d'énergie (101, 801, 1001) et un interrupteur de sécurité (102, 302, 402, 502, 802), dans lequel l'interrupteur de sécurité est couplé en série, via un premier conducteur électrique (308, 409, 708) et un deuxième conducteur électrique (309, 404, 709), entre un premier connecteur électrique (306, 408) et un deuxième connecteur électrique (307, 403), dans lequel l'interrupteur de sécurité comprend un élément de commutation (QI), dans lequel l'élément de commutation comprend un transistor comprenant une borne de source (Vs) couplée au premier conducteur électrique, une borne de drain (Vd) couplé au deuxième conducteur électrique et une borne de grille (Vg), dans lequel le circuit d'énergie auxiliaire comprend un convertisseur CC/CC (720), dans lequel une première entrée du convertisseur est couplée à la borne de source et une deuxième entrée du convertisseur est couplée à la borne de drain, et dans lequel le premier connecteur électrique est connecté à une première source d'énergie d'une pluralité de sources d'énergie et le deuxième connecteur électrique est connecté à une deuxième source d'énergie de la pluralité des sources d'énergie ;
le contrôle, en réponse à la détection de l'état potentiellement dangereux, par l'organe de contrôle de l'interrupteur de sécurité via la borne de grille servant de borne de contrôle de l'interrupteur de sécurité pour déconnecter le premier connecteur électrique du deuxième connecteur électrique,
la détermination, par l'organe de contrôle, que l'état potentiellement dangereux a été restauré;
en réponse à la détermination, le contrôle par l'organe de contrôle, de l'interrupteur de sécurité via la borne de grille pour connecter le premier connecteur électrique au deuxième connecteur électrique; et
la conversion, par le convertisseur du circuit d'énergie auxiliaire (304, 504, 704, 704a), de la tension drain-source à ses entrées en une tension plus importante à sa sortie pour alimenter l'organe de contrôle,
dans lequel le contrôle de l'interrupteur de sécurité pour déconnecter le premier connecteur électrique du deuxième connecteur électrique comprend le réglage de l'élément commutation (QI) à un état OFF, et
dans lequel le contrôle de l'interrupteur de sécurité pour connecter le premier connecteur électrique au deuxième connecteur électrique comprend le réglage de l'élément commutation à un état ON.

11. Le procédé selon la revendication 10, dans lequel la détection de l'état potentiellement dangereux comprend la réception d'une mesure d'un paramètre électrique et la détermination que la mesure des paramètres électriques est révélatrice de l'état potentiellement dangereux.

12. Le procédé selon la revendication 11, dans lequel la réception de la mesure du paramètre électrique comprend la réception d'une mesure du courant électrique, et dans lequel la mesure des paramètres électriques indicatifs de l'état potentiellement dangereux comprend au moins une des mesures suivantes : une mesure de courant élevé, une mesure indiquant un changement dans le flux de courant, ou une mesure indiquant une discordance avec un autre paramètre électrique

13. Le procédé selon l'une quelconque des revendications 10 à 12, dans lequel la détermination que l'état potentiellement dangereux a été résolu comprend la réception, via un dispositif de communication (305, 505), d'une commande par un dispositif de contrôle du système

14. Le procédé selon l'une quelconque des revendications 10 à 12, comprenant en outre la réception, par l'organe de contrôle (303, 503), d'un signal de maintien en fonctionnement provenant d'un dispositif de commande du système, dans lequel la détection, par l'organe de contrôle, de l'état potentiellement dangereux, comprend le fait de ne pas recevoir le signal de maintien en fonctionnement.

15. Le procédé selon l'une quelconque des revendications 10 à 14, dans lequel l'organe de contrôle (303) est un circuit analogique.
